# EUROPEAN PATENT APPLICATION

(11) **EP 4 408 017 A1**
(43) Date of publication of application: **31.07.2024**
(21) Application number: 23214127.5
(22) Date of filing: 04.12.2023
(51) Int. Cl.: H04R 1/08, H04R 31/00, H04R 19/00, B81B 7/00, H04R 1/44, H04R 17/02, H04R 19/04, H04R 1/04

(54) **MEMS DEVICE WITH MEMBRANE COMPRISING LASER STRUCTURED NANOSTRUCTURES AND METHOD FOR MANUFACTURING SAME**

(30) Priority: 27.01.2023 EP 23153777
(71) Applicant: Infineon Technologies AG, 85579 Neubiberg (DE)
(72) Inventor: WASISTO, Hutomo Suryo, 81541 München (DE); ANZINGER, Sebastian, 83714 Miesbach (DE); STREB, Fabian, 93059 Regensburg (DE)
(74) Representative: Fischer, Florian

(57) **Abstract**

This disclosure concerns a method for producing a MEMS device (100), the method comprising a step of providing a substrate (110) comprising a first substrate surface (111) and an opposite second substrate surface (112), wherein the substrate (110) comprises a sacrificial layer (140) arranged at the first substrate surface (111), and a step of depositing a membrane material layer (114) onto the sacrificial layer (140). The membrane material layer (114) forms a free-standing membrane structure (130). The method further comprises a step of creating nanostructures (150) protruding from the membrane material layer (114), wherein the nanostructures (150) are created by applying a laser structuring process.

## Description

Embodiments of the present disclosure relate to a method for producing MEMS device (MEMS: microelectromechanical system) comprising a membrane with a liquid repellent membrane surface, wherein the membrane has at least one of oleophobic and hydrophobic characteristics.

### TECHNICAL BACKGROUND

MEMS-based systems are miniaturized systems that comprise a very small form factor. For example, pressure transducers may be provided as MEMS devices, wherein a small membrane may transduce mechanical oscillations of the membrane into electric signals, or vice versa. An example of a MEMS pressure transducer may be a tire pressure sensor that monitors air pressure in tires. A further example may be a MEMS microphone that transduces sound waves (as an example of air pressure), such as music or voice, into electric signals, which can then be converted into digital data. In the reverse direction, a MEMS speaker may convert digital data into sound by oscillating the membrane.

Due to their miniaturized size, MEMS pressure transducers require environmental protection because they can be influenced by several environmental ingress from the surrounding environment, for instance dust particles, water and moisture, which can then lead to lower robustness level and shorter operation time.

For example, currently available MEMS-based microphones often have failures when they are exposed to liquids, for example water droplets, salt-containing liquids, sweat or oil. In case water droplets containing conductive particles, such as salts, reach the MEMS microphone membrane via the bottom sound port, these particles can remain on the bottom membrane surface when the water has evaporated, which may often result in device contamination, corrosion and/or electrical shortcut (leakage). If this phenomenon occurs over a long time, the device may not work as it should, leading to lower robustness and shorter lifetime.

The bottom membranes of MEMS microphones typically possess planar surfaces comprising hydrophilic characteristic, which is typical for planar silicon surfaces. Thus, droplets of water or other liquids tend to adsorb onto the membrane surface. After the liquids have evaporated, solid materials (e.g., salts, particles, and other contaminants) that were contained in said evaporated liquids may remain on the membrane.

The commonly implemented solution to protect the membranes of MEMS microphones is by adding external discrete environmental barrier (EB) components, e.g., an EB membrane having hydrophobic / oleophobic characteristics, and which is placed either inside or outside the package lid covering the sound port. This solution has, however, some drawbacks, such as high production cost, large package size, low acoustic performance, and limited usage for applications.

Therefore, it would be desirable to provide a MEMS device with a membrane comprising a liquid repellent membrane surface and an inherent oleophobic and/or hydrophobic characteristic without the above mentioned drawbacks.

This can be achieved by means of the herein disclosed MEMS device and the corresponding method for fabricating the MEMS device according to the independent claims. Further embodiments and advantageous aspects are suggested in the dependent claims.

One aspect concerns a method for producing a MEMS device, the method comprising a step of providing a substrate comprising a first substrate surface and an opposite second substrate surface, wherein the substrate comprises a sacrificial layer arranged at the first substrate surface. The method further comprises a step of depositing a membrane material layer onto the sacrificial layer, and a step of structuring a cavity into the substrate, the cavity extending between the second substrate surface and the sacrificial layer. The method further comprises a step of releasing the membrane material layer by removing the sacrificial layer from the cavity such that the cavity is adjacent to the membrane material layer, wherein the released membrane material layer forms a free-standing membrane structure covering the cavity. The method further comprises a step of creating nanostructures in at least one of the first and second surfaces of the membrane material layer, wherein the nanostructures protrude from the respective surface of the membrane material layer, wherein the nanostructures are created by applying a laser structuring process.

A further aspect concerns a MEMS - microelectromechanical system - device comprising a substrate having a cavity formed therein, the cavity extending vertically through the substrate, and a membrane material layer being attached to the substrate, said membrane material layer forming a horizontally extending free-standing membrane structure covering the cavity. The membrane material layer comprises a plurality of nanostructures for providing a liquid repellent membrane surface, wherein the nanostructures protrude from at least one of two opposing surfaces of the membrane material layer. The nanostructures are created by laser structuring such that they are monolithically integrated in the membrane material layer.

In the following, embodiments of the present disclosure are described in more detail with reference to the figures, in which
- Fig. 1A: shows a schematic cut perspective view of a MEMS device according to an embodiment being configured as a discrete environmental barrier,
- Fig. 1B: shows a schematic side view of the MEMS device of Figure 1A,
- Fig. 2A: shows a schematic cut perspective view of a MEMS device according to an embodiment being configured as a MEMS-based single backplate microphone,
- Fig. 2B: shows a schematic side view of the MEMS device of Figure 2A,
- Fig. 3A: shows a schematic cut perspective view of a MEMS device according to an embodiment being configured as a MEMS-based sealed dual-membrane microphone,
- Fig. 3B: shows a schematic side view of the MEMS device of Figure 3A,
- Fig. 4: shows a schematic perspective view of upright three-dimensional nanostructures to be used in combination with a membrane structure according to an embodiment,
- Fig. 5: shows a schematic perspective view of some further upright three-dimensional nanostructures to be used in combination with a membrane structure according to an embodiment,
- Fig. 6: shows a schematic perspective view of some further upright three-dimensional nanostructures to be used in combination with a membrane structure according to an embodiment,
- Figs. 7A-7E: show schematic side views of different geometrical shapes of upright nanostructures to be used in combination with a membrane structure according to different embodiments,
- Fig. 8: shows a schematic side view of upright three-dimensional nanostructures being coated with an organic self-assembled monolayer according to an embodiment,
- Fig. 9: shows a schematic side view of upright three-dimensional nanostructures being decorated with nanowires according to an embodiment,
- Fig. 10A: shows a schematic side view of a MEMS-based package according to an embodiment, wherein the package comprises a MEMS device according to an embodiment, the MEMS device being configured as a MEMS-based single backplate microphone,
- Fig. 10B: shows a schematic side view of a MEMS-based package according to an embodiment, wherein the package comprises a MEMS device according to an embodiment, the MEMS device being configured as a MEMS-based sealed dual membrane microphone,
- Fig. 10C: shows a schematic side view of a MEMS-based package according to an embodiment, wherein the package comprises a MEMS device according to an embodiment, the MEMS device being configured as a MEMS-based discrete environmental barrier,
- Figs. 11A-11F: show method steps of a method for fabricating a MEMS device according to an embodiment, wherein the nanostructures are created in a first membrane surface by means of a laser structuring process,
- Fig. 12: shows an embodiment, wherein the laser structured nanostructures are created in an opposite second membrane surface,
- Figs. 13A-13C: show method steps of a method for fabricating a MEMS device according to an embodiment, wherein the nanostructures are created in the membrane material layer and in portions of the substrate by means of a laser structuring process,
- Figs. 14A-14B: show method steps of a method for fabricating a MEMS device according to an embodiment, wherein the laser structured nanostructures are created in nanopillars being previously created by lithography,
- Figs. 15A-15C: show enlarged sections of a membrane material layer comprising nanopillars being created by lithography, wherein the laser structured nanostructures are created in said nanopillars and gaps in between,
- Fig. 16: shows a MEMS device comprising a membrane material layer with protruding laser structured nanostructures, wherein at least the membrane material layer is coated with a Self Assembled Monolayer (SAM),
- Figs. 17A-17F: show method steps of a method for fabricating a MEMS device according to an embodiment, wherein the horizontally extending membrane structure and the upright nanostructures are made from the same material,
- Figs. 18A-18F: show method steps of a method for fabricating a MEMS device according to an embodiment, wherein the horizontally extending membrane structure and the upright nanostructures are made from different materials,
- Figs. 19A-19J: show method steps of a method for fabricating a MEMS device according to an embodiment, wherein the horizontally extending membrane structure and the upright nanostructures are directly structured into the substrate material, and
- Figs. 20A-20H: show method steps of a method for fabricating a MEMS device according to an embodiment, wherein the horizontally extending membrane structure is directly structured into the substrate material and wherein the upright nanostructures are grown on the substrate material.

### DESCRIPTION OF THE FIGURES

Equal or equivalent elements or elements with equal or equivalent functionality are denoted in the following description by equal or equivalent reference numerals.

Method steps which are depicted by means of a block diagram and which are described with reference to said block diagram may also be executed in an order different from the depicted and/or described order. Furthermore, method steps concerning a particular feature of a device may be replaceable with said feature of said device, and the other way around.

In the following description, a MEMS-based microphone will be mentioned as a non-limiting example for a MEMS device. However, other MEMS devices with a membrane structure comprising a plurality of upright nanostructures also fall under the scope of protection according to the herein described innovative concept.

Furthermore, terms like horizontally and vertically will be used in the following description. Of course, these terms are to be understood in relation to each other, but not necessarily in relation to the earth's horizon. Accordingly, the term horizontally may be synonymously used with "extending in a first direction / plane", while the term vertically may be synonymously used with "extending in a second direction / plane", the second direction / plane being perpendicular to the first direction / plane. For example, a substrate may comprise a primary extension direction, which may also be referred to as the substrate plane. For example, the term "horizontally" is to be understood as "parallel to the substrate plane" or "in plane", while the term "vertically" is to be understood as "perpendicular to the substrate plane".

Furthermore, upright nanostructures may be described, wherein said upright nanostructures may be arranged on a membrane structure. The term "upright" means that the nanostructures may extend away from the membrane structure, for example in an upward direction. For example, if the membrane structure may extend horizontally, the nanostructures may extend substantially vertically from the membrane structure. Whenever the term "vertically extending" is used in the present disclosure, it is within the scope of the present disclosure that the nanostructures may not be perfectly vertical, but that the nanostructures may be slightly tilted. For example, the terms "upright" and "vertically extending" may include that the nanostructures may be skew and may extend away from the membrane structure in an angle of 90° ±25°. Furthermore, some embodiments refer to a plurality of nanostructures that may be arranged, for instance, in a nanostructure array. Accordingly, the present disclosure always refers to a majority (i.e. at least 50%) of the nanostructures. For example, if the present disclosure mentions that the nanostructures are upright, it means that at least 50% of the nanostructures are upright. In real life, it may be possible that several hundreds or thousands of nanostructures may be present, wherein most of them are upright, e.g., substantially vertical, while a few percent of them may not be upright (less than 75° or more than 115°). Furthermore, some embodiments may describe horizontally extending membrane structures as non-limiting examples for membrane structures in general. In such embodiments, vertically extending nanostructures may be described as non-limiting examples of upright nanostructures. Accordingly, the terms "vertically extending" and "upright" may be used synonymously in the present disclosure.

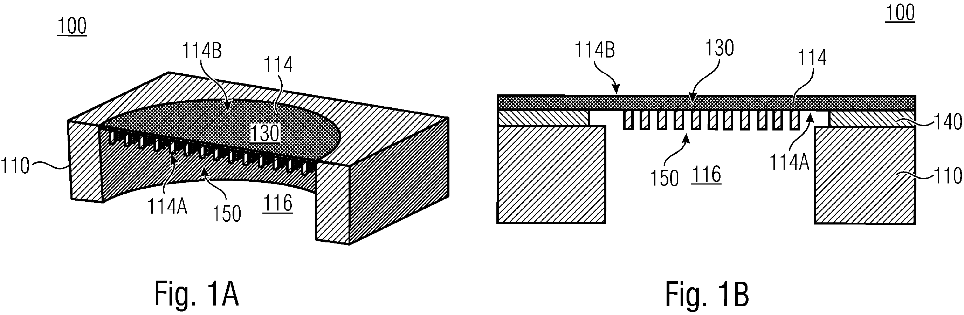

Figures 1A and 1B show a first embodiment of a MEMS device 100 according to the herein described innovative concept. The MEMS device 100 comprises a substrate 110. For example, the substrate 110 may comprise or be made from silicon. The substrate 110 comprises a vertically extending cavity 116 that may extend completely through the substrate 110.

The MEMS device 100 further comprises a horizontally extending membrane structure 130. For example, the membrane structure 130 may comprise or be made from polysilicon. The membrane structure 130 covers the cavity 116. As will be described in more detail below, the membrane structure 130 may be created from a membrane material layer 114 being deposited on a sacrificial layer 140 (e.g., TEOS: tetraethoxysilane or tetraethyl orthosilicate). The sacrificial layer 140 may be sandwiched between the substrate 110 and the membrane material layer 114 and may connect the membrane structure 130 with the substrate 110. Alternatively, the membrane structure 130 may be adhered to the substrate 110, e.g., by means of an adhesive.

According to the present innovative concept, a plurality of upright (e.g., vertically extending) nanostructures 150 is created in the membrane material layer 114 by applying a laser structuring process, such that the nanostructures 150 protrude from at least one of two opposing membrane surface 114A, 114B.

In particular, the horizontally extending membrane material layer 114 comprises a first membrane surface 114A facing the cavity 116, and an opposite second membrane surface 114B facing away from the cavity 116. As exemplarily depicted in Figures 1A and 1B, the protruding nanostructures 150 may be arranged on the first membrane surface 114A. Additionally or alternatively, the protruding nanostructures 150 may be arranged on the second membrane surface 114B. This holds for each and every embodiment as discussed herein.

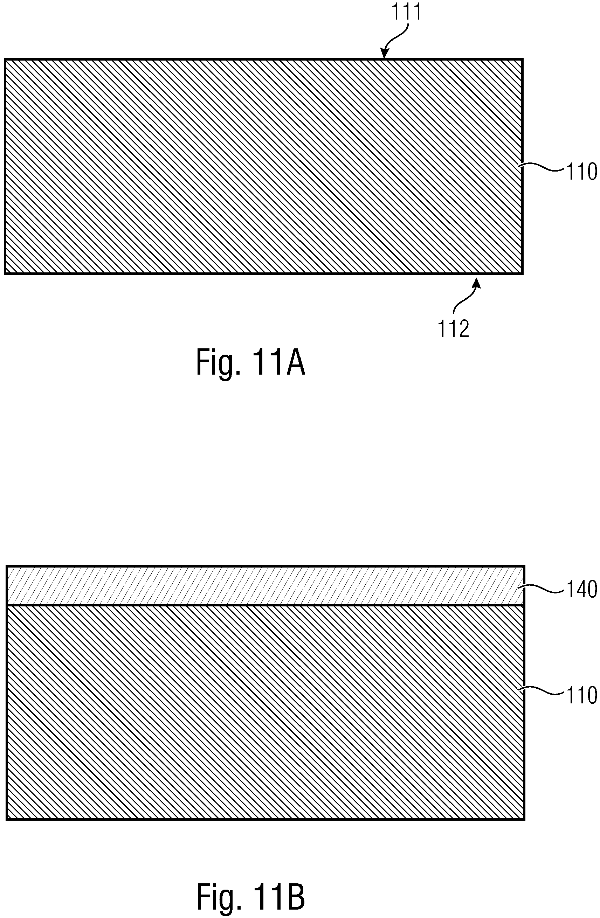

According to the herein disclosed innovative concept, the protruding nanostructures 150 are created by applying a laser structuring process, as will be discussed in more detail later with reference to Figures 11A to 16. Therefore, the nanostructures 150 may be monolithically integrated in the membrane material layer 114. Accordingly, the membrane material layer 114 forms a free-standing membrane structure 130 with integrated protruding nanostructures 150.

The protruding nanostructures 150 may extend substantially perpendicular to the membrane structure 130. The protruding nanostructures 150 provide for a self-cleaning surface characteristic exploiting the so-called lotus effect. Accordingly, the protruding nanostructures 150 provide for a liquid repellent membrane surface of the membrane structure 130. In particular, the protruding nanostructures 150 create a rough nanostructured membrane surface 114A, 114B that may provide for at least one of a hydrophobic or an oleophobic surface characteristic of the membrane structure 130.

In contrast, a membrane without these protruding nanostructures 150 may comprise a hydrophilic surface characteristic, i.e., liquids (water, oil, etc.) adhere to the membrane. If the liquid evaporates, solid matters (like salts, particles, and other contaminants) that are solved in said liquids, may remain on the membrane surface which may often result in device contamination, corrosion and/or electrical shortcut (leakage). The membrane structure 130 of the herein described innovative concept, instead, comprises a hydrophobic and/or oleophobic surface characteristic, i.e., liquids (water, oil, etc.) are repelled from the membrane structure 130. Said hydrophobic and/or oleophobic surface characteristics are provided by the protruding nanostructures 150.

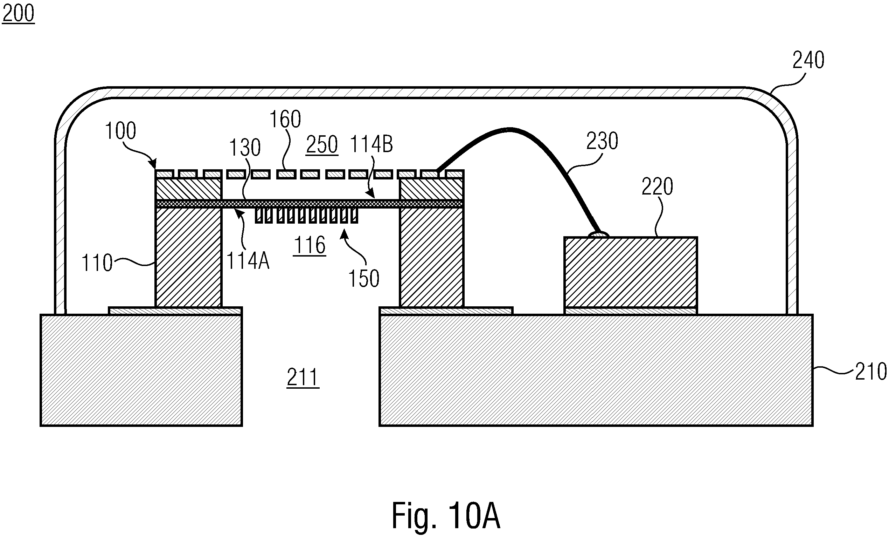

The MEMS device 100 as depicted in Figures 1A and 1B may be configured as a discrete environmental barrier structure, e.g., an environmental barrier mesh or membrane. Such environmental barrier structures 100 may be used in connection with MEMS microphones in order to protect the thin and fragile microphone membrane from ingress of environmental particles, moisture and other physical and/or chemical objects. Details will be discussed later with reference to Figures 10A to 10C.

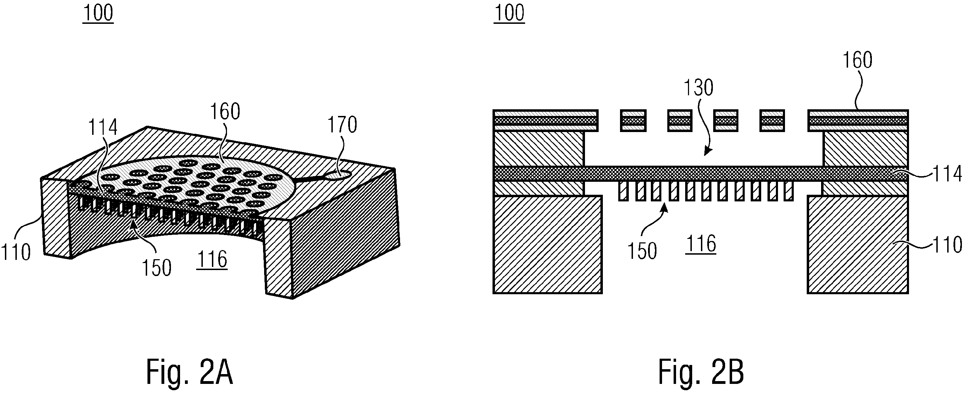

Figures 2A and 2B show a further embodiment of a MEMS device 100. In this non-limiting example, a so-called single backplate (SBP) MEMS-based microphone 100 is shown. In addition to the embodiment discussed above with reference to Figures 1A and 1B, the single backplate microphone 100 comprises an electrode structure 160 that can be electrically connected, e.g., by means of pads / terminals 170, to a circuitry (not shown). For example, the electrode structure 160 may comprise or be made from silicon nitride, Si₃N₄.

The membrane structure 130 may be configured as a microphone membrane that can oscillate in response to acoustic waves. The acoustic waves may enter the microphone package through a so-called sound port. The depicted single backplate microphone 100 may be mounted over the sound port, such that the acoustic waves may enter the vertically extending cavity 116 and arrive at the bottom surface of the membrane structure 130.

As mentioned above, the upright (e.g., vertically extending) nanostructures 150, which protrude from the membrane structure 130, may provide for a hydrophobic / oleophobic surface characteristic of the membrane structure 130. Thus, liquids contained in the air that is transferred by the acoustic waves may be repelled from the hydrophobic and/or oleophobic membrane surface. Accordingly, it is advantageous if the protruding nanostructures 150 are provided at a membrane surface that faces a source of environmental liquids, for example the sound port. Thus, in this non-limiting example, the protruding nanostructures 150 may face the cavity 116 and may vertically extend into the cavity 116. However, as will be explained below, the protruding nanostructures 150 may additionally or alternatively face away from the cavity 116 and may vertically extend away from the cavity 116. In other words, the protruding nanostructures 150 may be arranged on either one of the two membrane surfaces 114A, 114B or on both membrane surfaces 114A, 114B.

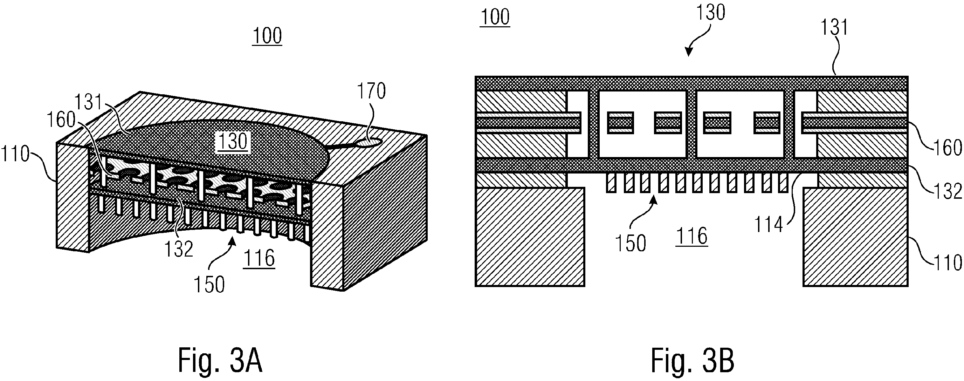

Figures 3A and 3B show a further embodiment of a MEMS device 100. In this non-limiting example, a so-called sealed dual-membrane (SDM) MEMS-based microphone 100 is shown. In addition to the embodiments discussed above, the sealed dual-membrane microphone 100 comprises a membrane structure 130 having a first membrane portion 131 and a second membrane portion 132. An electrode structure 160 is sandwiched between the first and second membrane portions 131, 132. While the membrane portions 131, 132 may be flexible, the electrode structure 160 may be a rigid electrode structure, such as a backplate or a stator, for example.

At least one of the first and second membrane portions 131, 132 may comprise the above described upright nanostructures 150 that protrude from the respective membrane portion 131, 132. Also in this case, it is advantageous if the protruding nanostructures 150 are provided at a membrane surface that faces a source of environmental liquids, for example the sound port. Thus, in this non-limiting example, the protruding nanostructures 150 may be arranged on the second membrane portion 132 facing the cavity 116.

The protruding nanostructures 150 may be configured as upright (e.g., vertically extending) nanospikes, nanotubes, nanofins, nanopillars, nanowhiskers, nanowalls, nanocircular walls, black silicon, and many more, while various other geometric designs and shapes are possible. In any case, the protruding nanostructures 150 may be configured as single, free-standing 3D elements, that protrude from a plane surface, e.g, from at least one of the two opposing membrane surfaces 114A, 114B of the membrane structure 130. The protruding nanostructures 150 may not be connected to each other, i.e., they are configured as individual unconnected elements. This is a difference compared to meshes and grids, which may sometimes be used as environmental barrier structures. Meshes and grids comprise a plurality of single mesh segments / grid segments that are all connected to each other to form the mesh / grid structure.

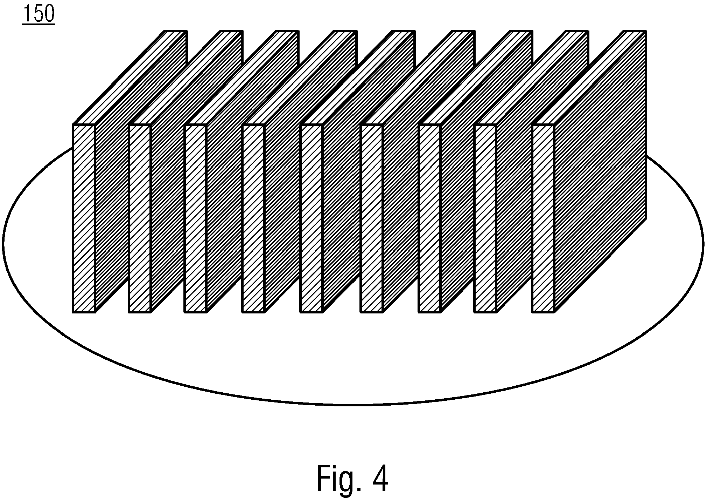

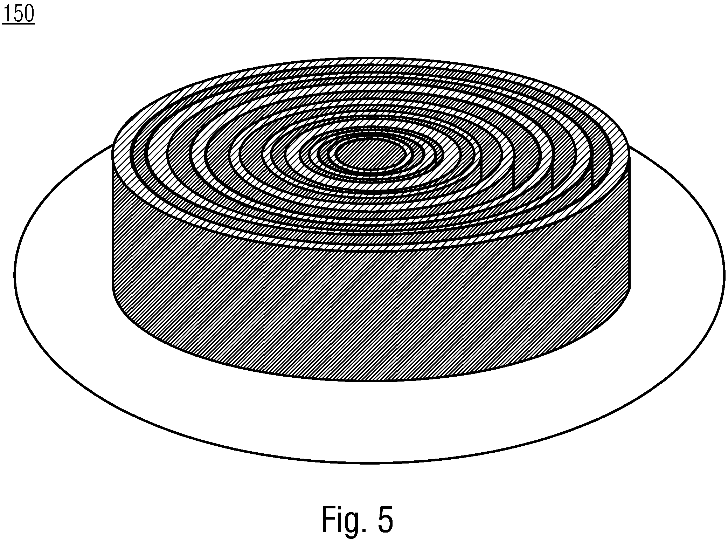

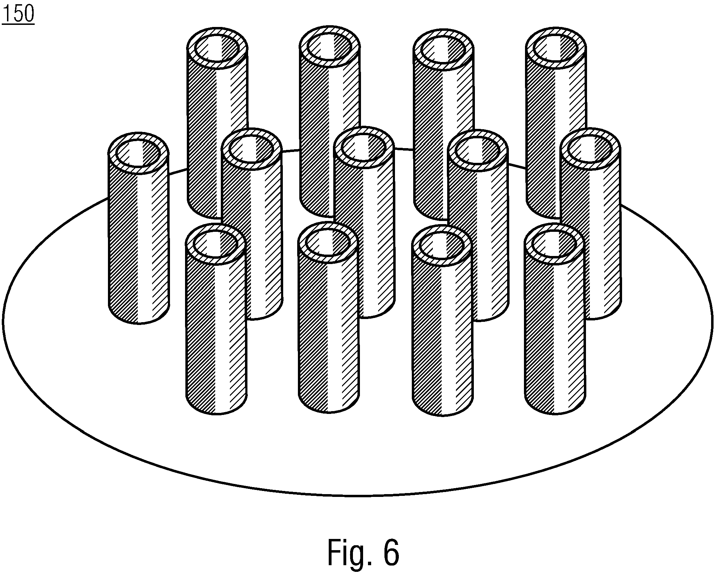

Figures 4 to 6 show some non-limiting examples of protruding nanostructures 150 being configured as single free-standing and unconnected 3D elements. Figure 4 shows protruding nanostructures 150 being configured as single free-standing and unconnectedupright walls or plates being consecutively arranged along a (straight or curved) line. Figure 5 shows protruding nanostructures 150 being configured as single free-standing and unconnected concentric walls. Figure 6 shows protruding nanostructures 150 being configured as single free-standing and unconnected (hollow) nanotubes.

Summarizing in a more general terminology, the protruding upright nanostructures 150 may be configured as single unconnected three-dimensional geometric structures extending away from the membrane structure 130. For example, the protruding upright nanostructures 150 may extend into a direction that is substantially perpendicular to the lateral extension of the membrane structure 130.

For example, the single unconnected nanostructures 150 may be configured as single upright nanopillars protruding and extending away from the membrane structure 130. Nanopillars are pillar-shaped nanostructures, approximately a few nanometers (e.g. 10 nm to 1.000 nm) in diameter, that can be grouped together in lattice like arrays. In such an array configuration, the protruding nanostructures 150 may be densely arranged next to each other. According to an embodiment, the plurality of protruding nanostructures 150 may comprise an area density of 10⁶ - 10¹⁰ nanostructures per cm².

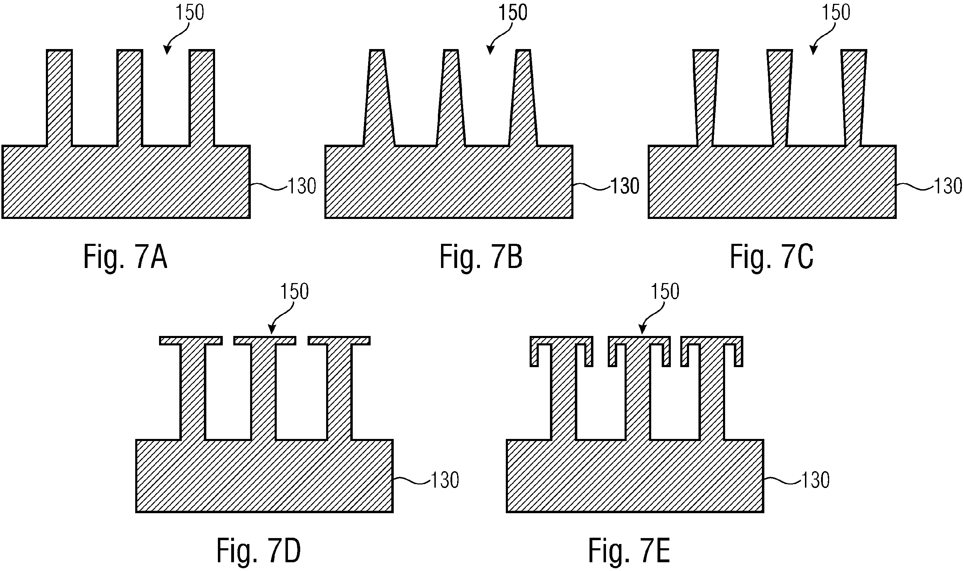

In some embodiments, the protruding nanostructures 150 may comprise a geometrical shape similar to a frustum cone. However, various other geometrical shapes are possible, as exemplarily depicted in Figures 7A to 7E. As shown in Figure 7A, the upright nanostructures 150 may comprise a geometrical shape similar to a straight cylinder protruding from the membrane structure 130. As shown in Figure 7B, the upright nanostructures 150 may comprise a geometrical shape similar to a frustum cone protruding from the membrane structure 130. As shown in Figure 7C, the upright nanostructures 150 may comprise a geometrical shape similar to an inverted frustum cone protruding from the membrane structure 130. As shown in Figure 7D, the upright nanostructures 150 may comprise a T-shape, i.e., a geometrical shape similar to the letter 'T', and they may protrude from the membrane structure 130. As shown in Figure 7E, the upright nanostructures 150 may comprise a multifaceted T-shape, i.e., a geometrical shape similar to the letter 'T' with additional contoured walls (e.g., reentrant structure), and they may protrude from the membrane structure 130. The different geometrical shapes may lead to different hydrophobic and/or oleophobic surface characteristics of the protruding nanostructures 150.

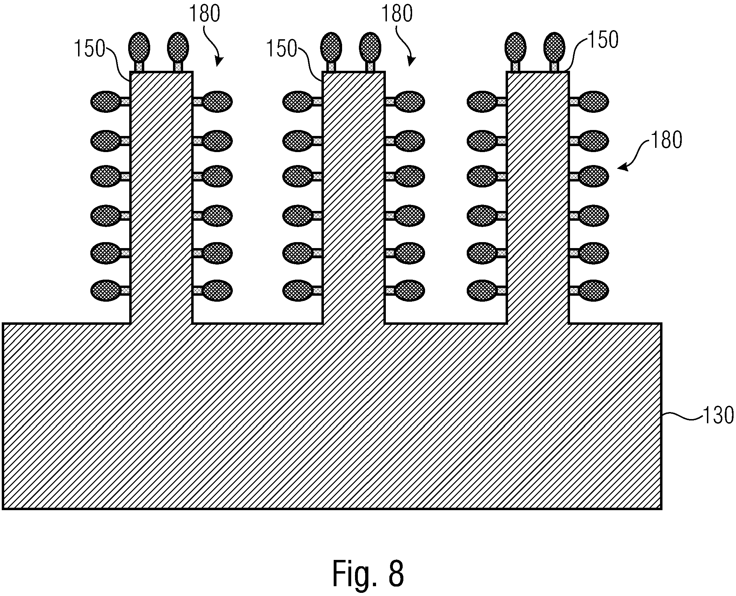

Besides different geometrical shapes, further advanced surface chemistry modification can be realized by introducing organic self-assembled monolayers, so-called SAMs. For example, Figure 8 shows an embodiment, wherein the protruding nanostructures 150 may be coated with organic self-assembled monolayers. Nanostructures 150 being coated with SAMs exhibit an enhanced level of hydrophobicity and/or oleophobicity compared to uncoated nanostructures 150. Using this combined chemical/physical method, the SAM-coated nanostructures 150 can increase the resulting water or liquid contact angle on their surface and can repel not only water but also other liquids (e.g., oil) resulting in (super-)hydrophobic or omniphobic surfaces.

Different self-assembled monolayers, and in particular silane-based SAMs, may be used for coating the protruding nanostructures 150. For example, the organic self-assembled monolayers may comprise, or may consist of, at least one of:
- Fluoroalkylsilanes (FAS),
- Perfluorodecyltrichlorosilane (FDTS),
- Heptadecafluoro-1,1,2,2-tetrahydrodecyltrichlorosilane (HDFS),
- Tridecafluoro-1,1,2,2-tetrahydrooctyltrichlorosilane (FOTS),
- Octadecyltrichlorsilane (ODTS),
- Methyltrimethoxysilane (MTMS),
- Bis(trimethylsilyl)amine or hexamethyldisilazane (HMDS),
- (3-Aminopropyl)triethoxysilane (APTES),
- Dichlorodimethylsilane (DDMS),
- Octadecyltrimethoxysilane (OTMS),
- Ethyltriethoxysilane (ETES), and
- 1H,1H,2H,2H-perfluorooctyltriethoxysilane (HFOTES).

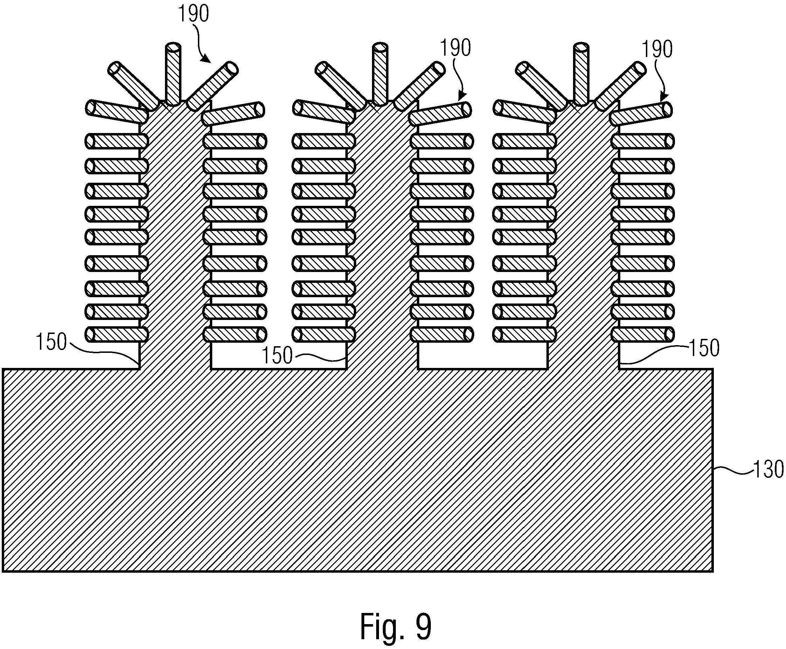

Figure 9 shows a further embodiment, wherein the protruding nanostructures 150 may comprise inorganic nano-elements 190, e.g., nanodots or nanowires, protruding from a surface of the nanostructures 150. Nanostructures 150 comprising additional nano-elements 190 exhibit an enhanced level of hydrophobicity and/or oleophobicity compared to bare/naked nanostructures 150.

The inorganic nano-elements 190 may be grown on the surface of the nanostructures 150. For example, a suitable material, for example zinc oxide (ZnO), may be used for creating the nano-elements 190. For example, for creating ZnO nanowires, a zinc oxide film may be deposited onto the surface of the nanostructures 150 using e.g., a sputtering technique for forming ZnO nanoseeds. The growth of the ZnO nanowires can then be realized by employing e.g., a chemical bath deposition (CBD) process. Other alternative methods (e.g., hydrothermal method, vapor-liquid-solid process, spray pyrolysis, chemical vapor deposition, molecular beam epitaxy, electrodeposition, atomic layer deposition, and pulsed laser deposition) can also be opted to grow or deposit ZnO layer and create ZnO nanostructures. This combination with ZnO nanowires is beneficial for the case of coarse nanostructures 150 (e.g. nanostructures 150 with large pitch or distance among them). ZnO nano-elements 190 may be advantageously grown on silicon-based nanostructures 150.

In result, the grown nano-elements 190 may protrude from the nanostructures 150, and they may extend substantially perpendicular from the surface of the nanostructures 150. Accordingly, the nanostructures 150 may comprise a tree-like shape. Each of the tree-like nanostructures 150 may comprise a plurality of inorganic nano-elements 190, e.g., nanowires.

As mentioned above, the nanostructures 150 may provide for a hydrophobic and/or oleophobic and/or superhydrophobic and/or omniphobic surface characteristic of the membrane structure 130. To explain these surface characteristics, imagine an untreated planar silicon surface on which a water droplet is applied. Planar silicon surfaces in general comprise a hydrophilic surface characteristic, i.e., liquids are adhered to the planar surface due to its low surface roughness and, thus, its large surface energy. A hydrophilic surface comprises a small water contact angle. For example, the water contact angle may be around 5° to 20°.

In turn, a nanostructured silicon surface, for example the herein described rough nanostructured membrane surfaces 114A, 114B of the membrane structure 130 with the protruding nanostructures 150, may comprise a larger water contact angle of at least 120° or at least 150°. Therefore, a water droplet being applied to the nanostructured membrane surface 114A, 114B almost stays in a perfect sphere shape. This is due to the higher surface roughness and, thus, lower surface energy provided by the nanostructures 150. Accordingly, the membrane structure 130 comprising the protruding nanostructures 150 may comprise a hydrophobic or even superhydrophobic surface characteristic.

Superhydrophobic surfaces generally show water contact angles of greater than 150° (nearly perfect sphere) along with low contact angle hysteresis. Contact angle hysteresis is defined as the difference between measured values of the advancing and receding contact angles (the highest and lowest contact angles on such a structures).

Additionally or alternatively, the nanostructures 150 protruding from the membrane structure 130 may provide an oleophobic surface characteristic such that oils are repelled from the membrane surface, or even an omniphobic surface characteristic such that almost each and every liquid is repelled from the membrane surface.

Liquids that approach the nanostructured membrane 130 having superhydrophobic/omniphobic surface characteristics will bounce or roll off. Hence, the herein discussed nanostructures 150 are useful for water/liquid repellent and self-cleaning surfaces. The nanostructured membrane surface can be self-cleaning because any water/liquid droplets that contact it will roll off picking up any particles along with the operation of the moving membrane 130.

By adjusting the geometry (e.g., diameter, height, aspect ratio, pitch) of the nanostructures 150, the hydrophobicity / oleophobicity / omniphobicity level of the nanostructures 150 can be varied.

According to some embodiments, the protruding nanostructures 150 may comprise a diameter of 1 µm or less. If the nanostructures 150 may comprise a varying diameter, e.g., if they were configured as frustum cones, the diameter is measured at the thickest portion. Additionally or alternatively, the protruding nanostructures 150 may comprise a pitch, i.e., a distance between the centers of two adjacent nanostructures 150, said pitch comprising a ratio of at least pitch : diameter = 2:1. Additionally or alternatively, the protruding nanostructures 150 may comprise an aspect ratio (width-to-height) between 1:3 and 1:40. The authors of this disclosure have found that nanostructures 150 with high aspect ratio (e.g., x > 5) produce a larger contact angle (more hydrophobicity / omniphobicity) than those with low aspect ratio (e.g., 1 < x < 5).

As mentioned above with reference to Figures 1A to 3B, the MEMS device 100 may be configured as a MEMS-based microphone or as a discrete MEMS-based environmental barrier. The MEMS device 100 may be housed underneath a lid so as to produce a MEMS-based package, e.g., a microphone package.

Figure 10A shows a first embodiment of a MEMS-based package 200. The package 200 may comprise a component board 210, e.g., a printed circuit board (PCB). A MEMS device 100 according to the herein described innovative concept may be arranged on the component board 210. A circuitry 220 for controlling the MEMS device 100 may be arranged adjacent to the MEMS device 100. The MEMS device 100 may be electrically connected to the circuitry 220, for example by means of a bond wire 230.

The package 200 may further comprise a lid 240 being arranged on the component board 210. The lid 240 may cover the MEMS device 100 and the circuitry 220. The free space or cavity 250 underneath the hollow lid 240 may provide for an acoustic back volume.

The component board 210 may comprise a vertically extending through hole 211. In case the MEMS-based package 200 is a microphone package (as exemplarily depicted here), the through hole 211 may be referred to as a sound port through which acoustic waves may enter the cavity 250.

In this non-limiting example, the MEMS device 100 may be configured as a MEMS-based single backplate (SBP) microphone, as previously discussed above with reference to Figures 2A and 2B. Here, the horizontally extending membrane structure 130 may be configured as a microphone sound transducer membrane, wherein the upright nanostructures 150 protrude from the microphone sound transducer membrane 130. In this example, the protruding nanostructures 150 may be arranged on the first membrane surface 114A facing the through hole (sound port) 211. However, additionally or alternatively, the protruding nanostructures 150 may be arranged on the opposite second membrane surface 114B facing away from the through hole (sound port) 211. For any further details as to the single components belonging to said SBP microphone 100, it is referred to the discussion above.

As can be seen in Figure 10A, the SBP microphone 100 is arranged directly opposite to the sound port 211, e.g., above the sound port 211. The SBP microphone 100 is arranged such that it covers the sound port 211. When viewed from above, the horizontally extending membrane structure 130 circumferentially covers the sound port 211. In this non-limiting example, the protruding nanostructures 150 face the sound port 211.

As mentioned above, acoustic waves may enter the package 200 through the sound port 211. Since the sound port 211 is in fluid connection with the cavity 116, the acoustic waves may be further conveyed into the cavity 116 until reaching the membrane structure 130. The membrane structure 130 will be deflected in response to the impinging acoustic waves. The amplitude of deflection will be measured by the electrode structure 160.

The air through which the acoustic waves may travel may comprise moisture, e.g., liquids containing salt particles and the like. Since the herein described innovative membrane structure 130 comprises the protruding nanostructures 150, the membrane structure 130 shows a (super-)hydrophobic / omniphobic surface characteristic. Thus, intruding liquids and or any solid matter (like salts, particles, and other contaminants) contained in said liquids may be repelled from the surface of the membrane structure 130. This provides for a superior protection of the microphone membrane 130.

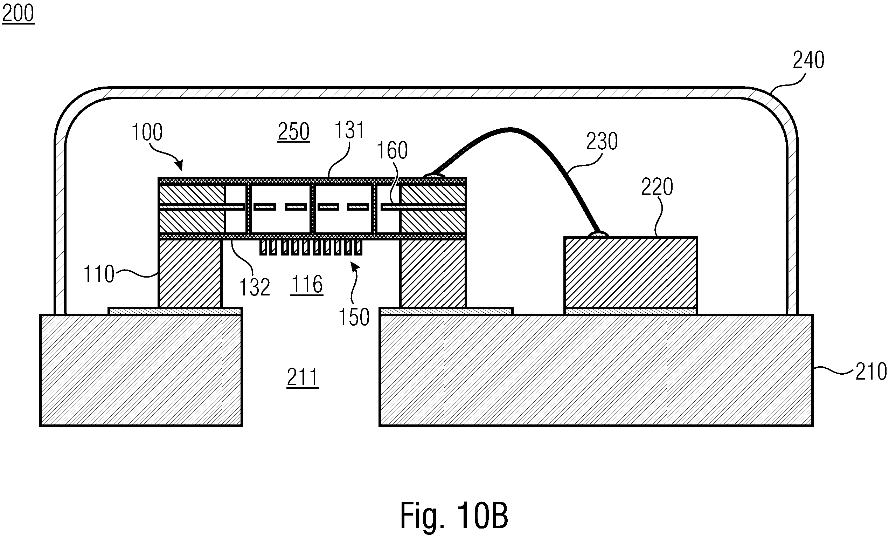

Figure 10B shows a further embodiment of a MEMS-based package 200 being configured as a microphone package. Like elements with like features, as discussed with reference to Figure 10A, are indicated with same reference numerals. Accordingly, for further details it is referred to the above discussion. A difference compared to the above discussed embodiment (c.f. Figure 10A) is the type of MEMS device 100 used. In this non-limiting example, the MEMS device 100 is configured as a sealed dual-membrane (SDM) MEMS-based microphone. Regarding technical details of the SDM microphone 100 it is referred to Figures 3A and 3B.

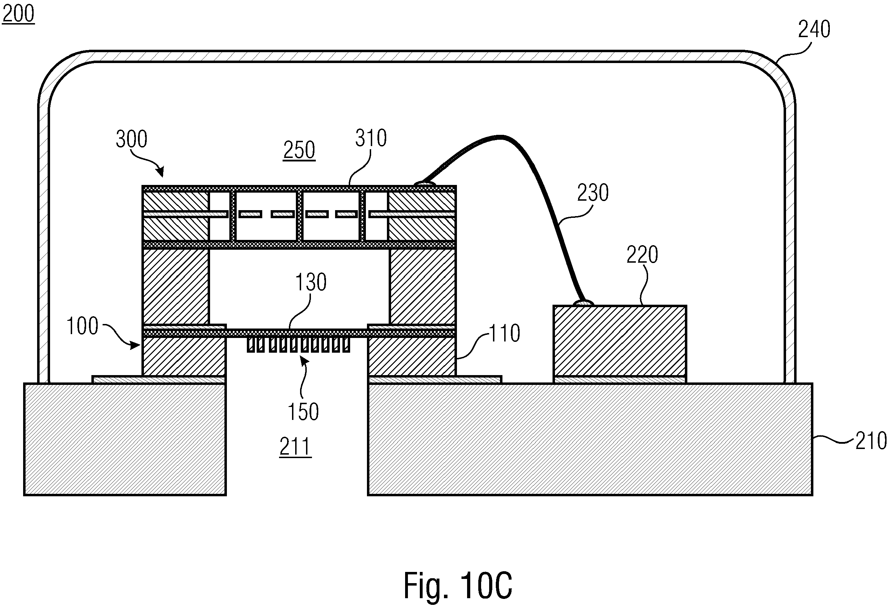

Figure 10C shows a further embodiment of a MEMS-based package 200. Again, like elements with like features, as discussed with reference to Figures 10A and 10B, are indicated with same reference numerals. In this non-limiting example, the MEMS device 100 according to the herein described innovative principle may be configured as a discrete MEMS-based environmental barrier structure. For details as to any elements comprised by said environmental barrier 100, it is referred to Figures 1A and 1B above.

Furthermore, a MEMS-based microphone 300 is depicted. This MEMS-based microphone 300 may be a MEMS device 100 as discussed above, or a conventional MEMS-based microphone. In this non-limiting example, a conventional SDM microphone is depicted. However, it may also be possible that a SBP microphone may be used instead. The MEMS-based microphone 300 may comprise a microphone sound transducer membrane 310.

As can be seen in Figure 10C, the innovative MEMS device 100 may be arranged between the sound port 211 and the MEMS-based microphone 300. Thus, the MEMS device 100 being configured as an environmental barrier structure acts as an environmental barrier for protecting the MEMS microphone sound transducer membrane 310 from moisture and/or environmental particles.

The MEMS device 100 being configured as an environmental barrier structure comprises a horizontally extending environmental barrier membrane or mesh structure. In this non-limiting example, the innovative membrane structure 130 may be configured as the aforementioned environmental barrier membrane or mesh structure.

The membrane structure 130 may comprise the protruding nanostructures 150 as discussed herein. This provides for an improved hydrophobicity / omniphobicity level of the membrane structure 130. Thus, intruding liquids and or any solid matter (like salts, particles, and other contaminants) contained in said liquids may be repelled from the surface of the membrane structure 130. This provides for a superior protection of the downstream arranged microphone membrane 310.

In the previous sections, different embodiments of the MEMS device 100 were described. In the following, examples and embodiments of methods for manufacturing a MEMS device 100 will be discussed.

Figures 11A to 11F show an embodiment of a method for fabricating a MEMS device 100 as discussed herein. According to the herein discussed innovative principle, the above discussed protruding nanostructures 150 are created by applying a laser structuring process, as will be described in more detail below.

Figure 11A shows a first method step, wherein a substrate 110 is provided, the substrate 110 comprising a first substrate surface 111 and an opposite second substrate surface 112. The substrate 110 may comprise or consist of silicon.

Figure 11B shows a further method step, wherein a sacrificial layer 140 is arranged at the first substrate surface 111. The sacrificial layer 140 may comprise or consist of tetraethoxysilane (TEOS). Alternatively, the sacrificial layer 140 may comprise or consist of one or more oxides.

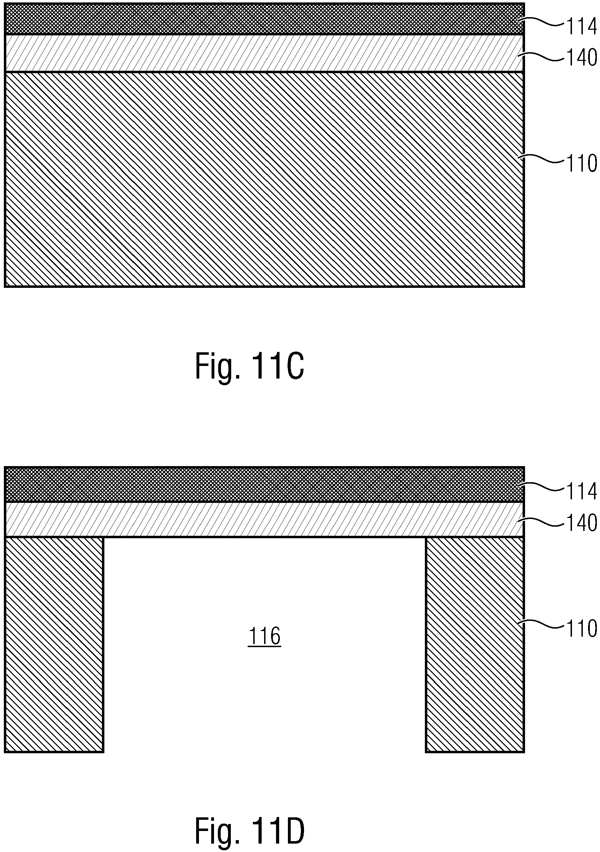

Figure 11C shows a further method step, wherein a membrane material layer 114 is deposited onto the sacrificial layer 140. A membrane material layer 114 may comprise or be made from one or more materials that are suitable for providing a MEMS-membrane, e.g., polysilicon.

Figure 11D shows a further method step, wherein a cavity 116 is structured into the substrate 110. The cavity 116 may be created by applying a suitable etching process, such as RIE or DRIE etching. The cavity 116 may extend between the second substrate surface 112 and the sacrificial layer 140. The cavity 116 may have the shape of a through hole that extends completely through the substrate 110 between the first and second substrate surfaces 111, 112.

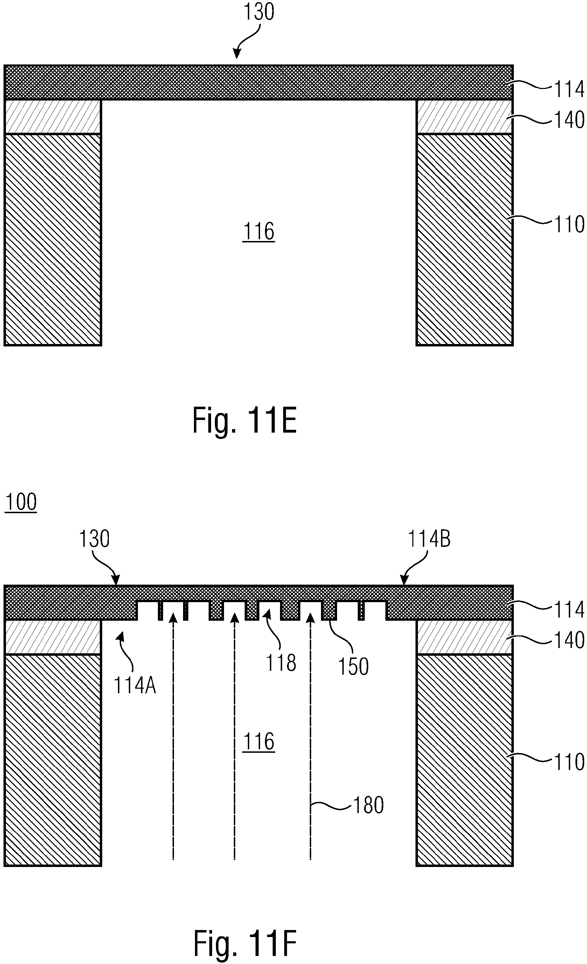

Figure 11E shows a further method step, wherein the membrane material layer 114 is released by removing the sacrificial layer 140 from the cavity 116, i.e. portions of the sacrificial layer 140 that were previously sitting inside the cavity (c.f. Figure 11D) are removed, such that only residual portions of the sacrificial layer 140 may remain between substrate portions and the membrane material layer 114. The sacrificial layer 140 may be removed by applying a suitable etching process, such as a chemical wet etching process. After removing the above mentioned portions of the sacrificial layer 140, the cavity 116 is directly adjacent to the membrane material layer 114. Accordingly, the released membrane material layer 114 forms a free-standing membrane structure 130 covering the cavity 116.

Figure 11F shows a further method step, wherein nanostructures 150 are created in at least one of the first and second membrane surfaces 114A, 114B of the membrane material layer 114. According to the present innovative concept, the nanostructures 150 are created by applying a laser structuring process, wherein laser beams are schematically represented by arrows 180. The laser structuring can be applied prior to or after the step of releasing the membrane layer 114 (Fig. 11E).

The applied laser structuring process may use a femto second laser or a pico second laser. This may have the advantage that membrane material may change from solid to gas, without an intermediate liquid state, and heat input may be limited to specific spots. Thus, the nanostructures 150 may be formed from the membrane material layer 114, or in other words, the nanostructures 150 may be monolithically integrated in the membrane material layer 114.

Accordingly, the step of creating the nanostructures 150 may comprise a step of removing portions 118 of the membrane material layer 114 by means of one or more laser beams 180 being used in the applied laser structuring process, wherein the nanostructures 150 remain between the removed portions 118 of the membrane material layer 114, such that the nanostructures 150 are monolithically integrated in the membrane material layer 114.

Additionally or alternatively, the applied laser structuring process may comprise Direct Laser Interference Patterning (DLIP), wherein interference patterns may be directly imprinted into the membrane surface 114A, 114B of the membrane material layer 114. Thereby, a plurality of nanostructures 150 may be created with a single laser beam.

The step of creating the nanostructures 150 may comprise distributing the nanostructures 150 in a random or periodic pattern along the respective membrane surface 114A, 114B of the membrane material layer 114.

The nanostructures 150 that are created according to the herein described innovative principle are not only monolithically integrated in the membrane material layer 114, but they also protrude from the respective membrane surface 114A, 114B of the membrane material layer 114. Thus, the protruding nanostructures 150 provide for an increased surface roughness (compared to unstructured plane membrane surfaces without nanostructures) of the respective membrane surface 114A, 114B thereby increasing the hydrophobicity and/or oleophobicity level of the membrane material layer 114 and, thus, of the membrane structure 130 created therefrom.

In the non-limiting example shown in Figure 11F, the nanostructures 150 are created in the first membrane surface 114A of the membrane material layer 114, said first membrane surface 114A facing the cavity 116, such that the nanostructures 150 also face the cavity 116. In this case, the one or more laser beams 180 is/are guided into the cavity 116 so as to reach the first membrane surface 114A of the membrane material layer 114 through the cavity 116. This may be performed as a last process step in the frontend production leading to a simplified processing of creating the protruding nanostructures 150 compared to other processes, such as lithography processes.

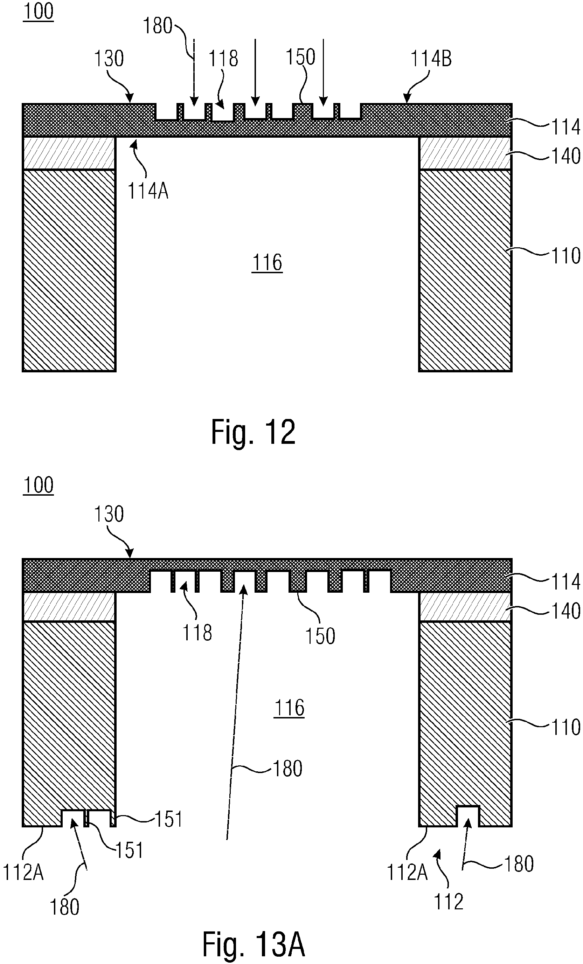

Figure 12 shows an alternative method step, wherein the protruding nanostructures 150 are created in the second membrane surface 114B, said second membrane surface 114B facing away from the cavity 116, such that the nanostructures 150 also face away from the cavity 116. In this case, the one or more laser beams 180 is/are guided over the second membrane surface 114B of the membrane material layer 114.

As a further alternative, which is not explicitly depicted here, the protruding nanostructures 150 may be created in the first and second membrane surfaces 114A, 114B.

Figure 13A shows an optional method step, wherein the one or more laser beams 180 being used in the applied laser structuring process is/are guided over an exposed portion 112A of the second substrate surface 112 that remains after creating the cavity 116. Accordingly, the remaining exposed portion 112A is located outside the cavity 116, such that additional nanostructures 151 are created in said exposed portions 112A of the second substrate surface 112. In this case, the additional nanostructures 151 may be formed integrally / monolithically with the laser-treated exposed portions 112A of the second substrate surface 112. Furthermore, the additional nanostructures 151 may protrude from the laser-treated exposed portions 112A of the second substrate surface 112 thereby increasing their surface roughness leading to an increased hydrophobicity / olephobicity.

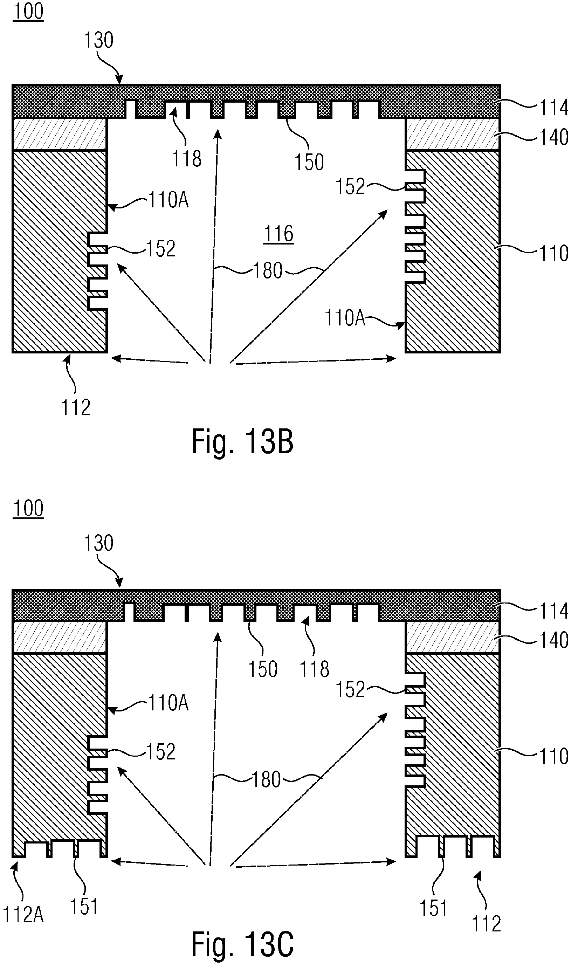

Figure 13B shows a further optional method step, wherein the one or more laser beams 180 being used in the applied laser structuring process is/are guided over one or more inner substrate portions 110A (e.g., inner side walls) residing inside the cavity 116, such that additional nanostructures 152 are created in said one or more inner substrate portions 110A. In this case, the additional nanostructures 152 may be formed integrally / monolithically with the laser-treated inner substrate portions 110A. Furthermore, the additional nanostructures 152 may protrude from the laser-treated inner substrate portions 110A thereby increasing their surface roughness leading to an increased hydrophobicity / olephobicity.

Figure 13C shows a further alternative, wherein the additional protruding nanostructures 151, 152 may be created in the exposed portions 112A of the second substrate surface 112 and in the inner substrate portions 110A residing inside the cavity 116.

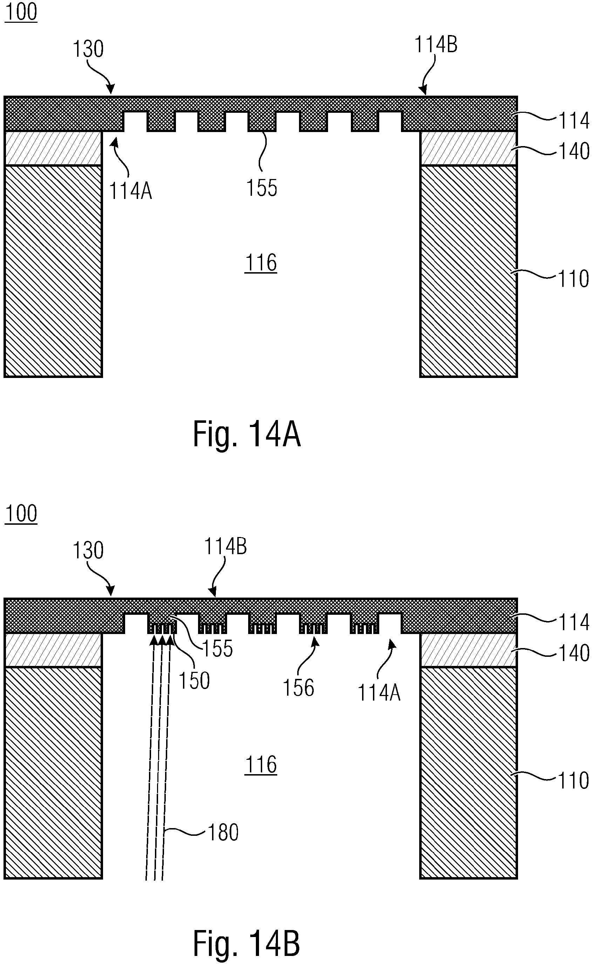

Figures 14A and 14B show a further embodiment of a method for producing the above discussed innovative MEMS device 100. This method is a combined method in which lithography is combined with laser structuring. In particular, prior to the step of creating the nanostructures 150 by applying the laser structuring process, the method comprises a step of creating nanopillars 155 in at least one of the first and second membrane surfaces 114A, 114B of the membrane material layer 114 by applying a lithography and etching process, wherein said nanopillars 155 protrude from the respective membrane surface 114A, 114B of the membrane material layer 114. In the example shown in Figure 14A, the nanopillars 155 being created by lithography are formed in the first membrane surface 114A.

As shown in Figure 14B, the nanostructures 150 are then created in said nanopillars 155 by applying the above discussed laser structuring process, wherein the laser beams are schematically depicted by means of arrows 180. In this example, the laser structured nanostructures 150 are created in a top surface 156 of the nanopillars 155, wherein said top surface 156 faces away from the membrane material layer 114, i.e. it faces the cavity 116. In result, the laser structured nanostructures 150 protrude from the nanopillars 155 created in the membrane material layer 114 by means of lithography and, as such, the nanostructures 150 protrude from the membrane material layer 114.

The nanopillars 155 created by lithography may comprise an average diameter that is at least ten times larger than an average diameter of the laser structured nanostructures 150. For example, the nanopillars 155 may comprise a diameter of 100 nm, and the laser structured nanostructures 150 may comprise a diameter of 10 nm.

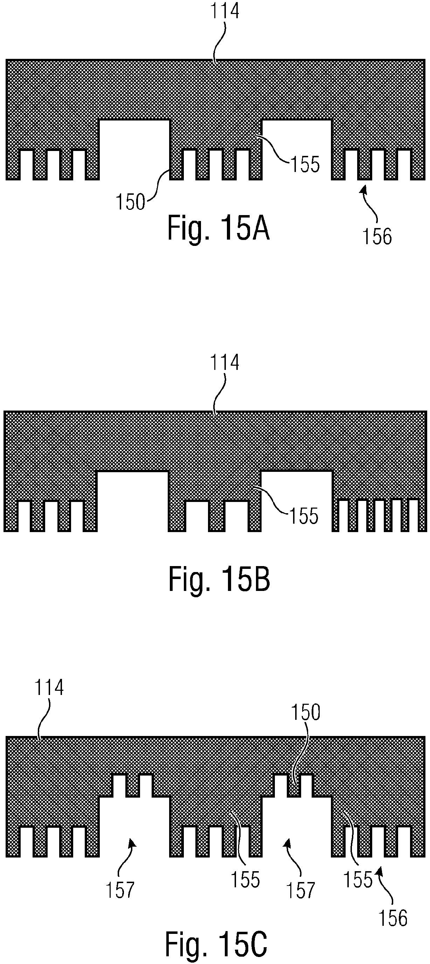

Figures 15A to 15C show some non-limiting examples of laser structured nanostructures 150 and how they can be structured into the nanopillars 155 by applying the laser structuring process. Figure 15A shows a first example that corresponds to the embodiment described above with reference to Figure 14B. Here, the laser structured nanostructures 150 are created in the top surface 156 of the nanopillars 155.

Figure 15B shows a further example, wherein the laser structured nanostructures 150 comprise different sizes. For example, the laser structured nanostructures 150 may comprise different diameters. Accordingly, the laser structured nanostructures 150 may be arranged more or less densely among each other. This may apply to each and every embodiment discussed herein.

Figure 15C shows a further example, wherein the step of creating the nanostructures 150 by applying the laser structuring process comprises a step of creating the nanostructures 150 in a recess 157 between two adjacent nanopillars 155. As exemplarily depicted in Figure 15C, the laser structured nanostructures 150 may be created inside the recess 157 in addition to the creation of laser structured nanostructures 150 in the top surfaces 156 of the nanopillars 155. Alternatively, but not explicitly depicted here, the laser structured nanostructures 150 may be created inside a recess 157only, i.e. without any laser structured nanostructures 150 being provided in the top surfaces 156 of the nanopillars 155.

The nanopillars 155 may also be referred to as nanowhiskers. In some embodiments, the above discussed nanopillars 155 may comprise a geometrical shape that is different to a pillar. However, for the sake of easy differentiation from the laser structured nanostructures 150, they may generally be referred to as nanopillars 155 within this disclosure. Furthermore, while the nanopillars 155 have been described as being created by means of lithography, other embodiments may include that the nanopillars 155 are created differently, for example also by means of laser structuring, or the nanopillars 155 may be deposited onto at least one of the membrane surfaces 114A, 114B.

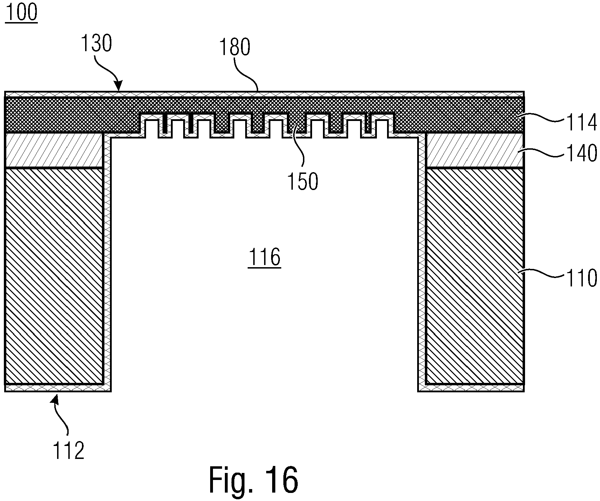

Figure 16 shows a further embodiment of the innovative method for producing a MEMS device 100. The method may further comprise a step of coating the membrane material layer 114, including the protruding nanostructures 150, with an organic Self Assembled Monolayer - SAM - 180, similar as described above with reference to Figure 8. Optionally, the SAM-coating 180 may further coat the inside of the cavity 116 and/or the exposed second substrate surface 112. Further optionally, the SAM-coating 180 may coat the entire MEMS device 100.

As discussed above, SAMs 180 may provide for an advanced surface chemistry modification of the coated surfaces. For example, nanostructures 150 being coated with SAMs exhibit an enhanced level of hydrophobicity and/or oleophobicity compared to uncoated nanostructures 150. Using this combined chemical/physical method, the SAM-coated nanostructures 150 can increase the resulting water or liquid contact angle on their surface and can repel not only water but also other liquids (e.g., oil) resulting in (super-)hydrophobic or omniphobic surfaces. Different self-assembled monolayers, and in particular silane-based SAMs, may be used for coating the protruding nanostructures 150.

As discussed herein, the laser structured nanostructures 150 improve hydrophobicity and/or oleophobicity of a treated surface, which expresses in a higher contact angle of 120° or more, or even 150° or more. Furthermore, SAMs do also improve hydrophobicity and/or oleophobicity of the treated surface.

However, the authors of the present disclosure surprisingly found out that the laser structured nanostructures 150 can improve the hydrophobicity / oleophobicity effect of SAMs. Accordingly, the laser structured nanostructures 150 in combination with SAMs do provide for an increased hydrophobicity / oleophobicity effect compared to SAMs alone or compared to nanostructures 150 alone. In other words, the combination of laser structured nanostructures 150 with SAMs lead to a higher contact angle compared to SAMs alone or compared to nanostructures 150 alone.

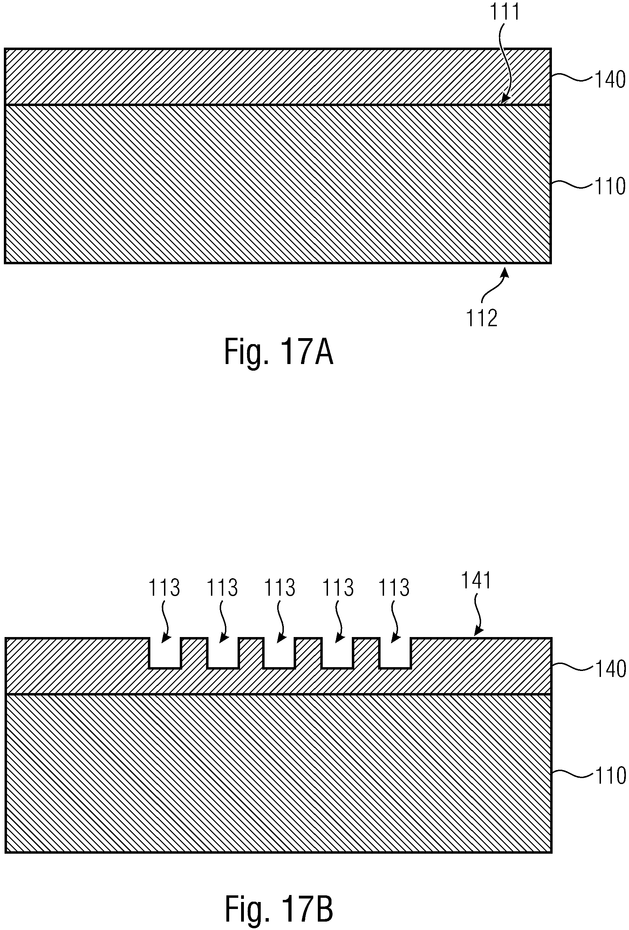

The herein discussed innovative laser structured nanostructures 150 may comprise a characteristic geometrical shape that allows to distinguish them from nanostructures 150 that have been created by methods different from laser structuring. For example, nanostructures 150 may also be created by lithography, deposition or growing, as will be discussed in more detail below with reference to Figures 17A to 20H.

For example, laser structured nanostructures 150 may comprise a non-flat top section, e.g., a sharp top. Furthermore, due to the laser beams 180 being applied to the membrane material layer 114 in slightly varying angles, the laser structured nanostructures 150 of two different MEMS devices 100 may comprise a similar pattern (in terms of roughness etc.) but with different orientations towards each other, i.e., offsets may not be exactly identical. Nanostructures being created by means of lithography, for instance, may comprise an identical pattern instead. Yet further, nanostructures being created by means of lithography may comprise a shape that is limited to certain angles around 90°. In turn, the shape of laser structured nanostructures 150 may differ from 90° and may vary.

Figures 17A to 17F show an embodiment of an exemplary method for fabricating a MEMS device 100, wherein the nanostructures 150 may be created by means of lithography. As shown in Figure 17A, a substrate 110 is provided, the substrate 110 comprising a first substrate surface 111 and an opposite second substrate surface 112. The substrate 110 may comprise or consist of silicon. A sacrificial layer 140 may be arranged at the first substrate surface 111. The sacrificial layer 140 may comprise or consist of tetraethoxysilane (TEOS). Alternatively, the sacrificial layer 140 may comprise or consist of one or more oxides.

As shown in Figure 17B, the sacrificial layer 140 may be structured / patterned, e.g., by using a lithography process. In particular, so-called nanoimprints 113 may be structured into the sacrificial layer 140. The nanoimprints 113 may be structured into an upper surface 141 of the sacrificial layer 140, i.e., into a surface of the sacrificial layer 140 that faces away from the substrate 110.

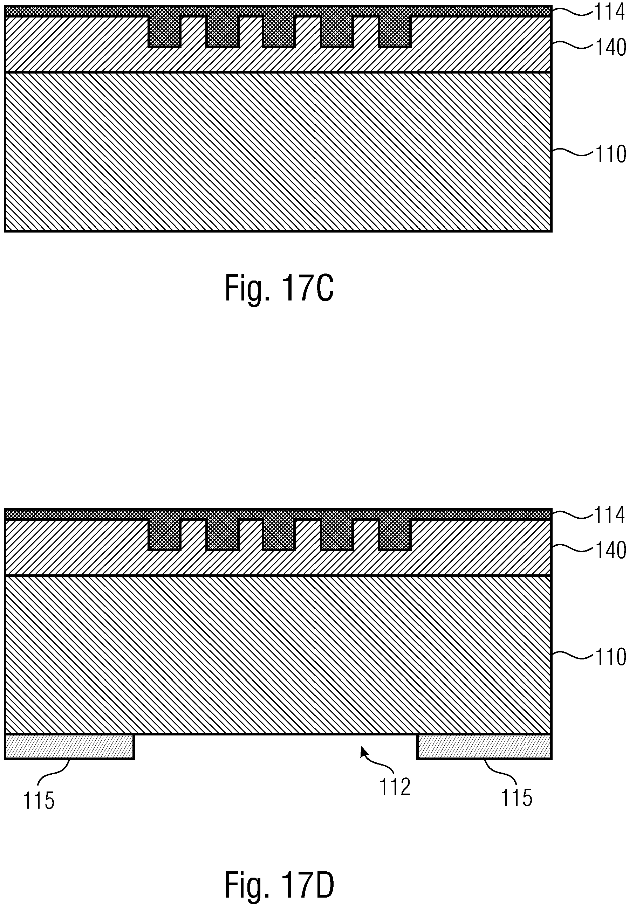

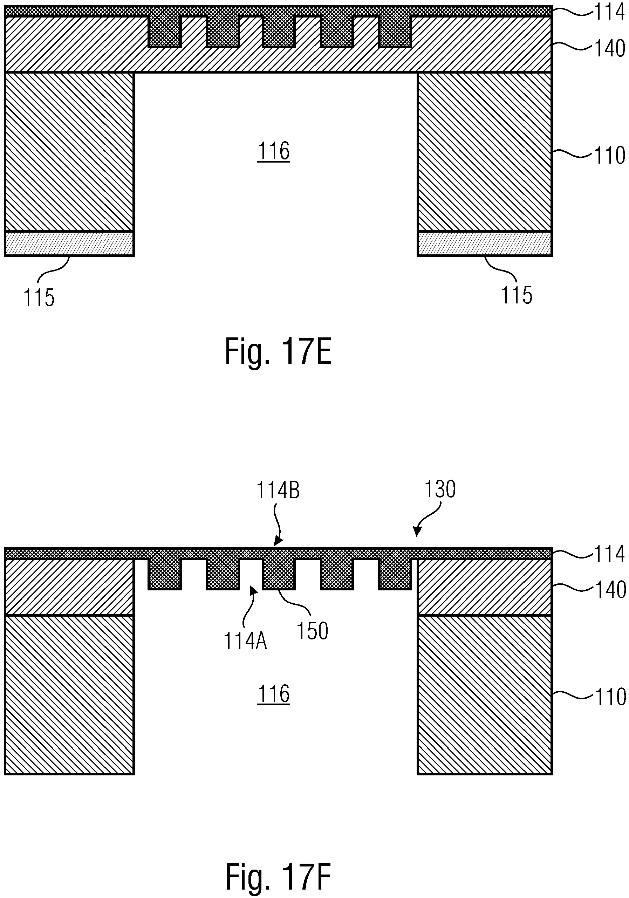

Figure 17C shows a further method step in which the nanoimprints 113 are filled with a first material 114, e.g., by using a deposition process, in which the first material 114 is deposited onto the structured sacrificial layer 140. The first material 114 may later form the membrane structure 130 with integrated protruding nanostructures 150 (c.f. Fig. 17F). Thus, the first material 114 may also be referred to as a membrane material layer 114, as described above. The first material 114 may comprise or consist of a CMOS-compatible material (CMOS: Complementary Metal-Oxide-Semiconductor). For example, the first material 114 may comprise or consist of at least one of (poly-)silicon, silicon nitride (Si₃N₄), carbon, polymers and metals.

Figure 17D shows a further method step, wherein a photoresist 115 is applied to the second surface 112 of the substrate 110. The photoresist 115 provides a negative form for a cavity 116 that is created in the next step, as shown in Figure 17E. A portion of the second substrate surface 112 that is located opposite to the filled nanoimprints 113 remains uncovered, i.e., it is not covered with the photoresist 115.

Figure 17E shows a further method step, in which the cavity 116 is structured into substrate 110. The cavity 116 is structured into that portion of the second substrate surface 112 that is not covered by the photoresist 115. The cavity 116 is structured through the entire substrate 110 until reaching the sacrificial layer 140. For example, the cavity 116 may be structured into the substrate 110 by using reactive ion etching (RIE). In result, the created cavity 116 is positioned opposite to the filled nanoimprints 113, and the created cavity 116 extends between the second substrate surface 112 and the sacrificial layer 140.

Figure 17F shows a further method step, in which the filled nanoimprints 113 are released by selectively removing the sacrificial layer 140 through the cavity 116. For example, a RIE or wet chemical etching process may be used for selectively removing portions of the sacrificial layer 140 that are located inside the cavity 116. In result, the (meanwhile released) first material 114 forms a horizontally extending membrane structure 130. Any of the first material 114 that was previously filled inside the (meanwhile released) nanoimprints 113 form upright (e.g., vertically extending) nanostructures 150 protruding from at least one of the membrane surfaces 114A, 114B of the membrane structure 130, as discussed above. Since the horizontally extending membrane structure 130 and the protruding nanostructures 150 are made from the same (first) material 114, the membrane structure 130 and the protruding nanostructures 150 are integrally formed. Furthermore, as exemplarily depicted here, the protruding nanostructures 150 may face and extend into the cavity 116.

Accordingly, the nanoimprints 113 (c.f. Figure 17B) may provide a negative form for the protruding nanostructures 150 (c.f. Figure 17F). Thus, it is preferable that the diameter, pitch and aspect ratio of the nanoimprints 113 correspond to the desired diameter, pitch and aspect ratio of the nanostructures 150 in order to provide the desired (super-)hydrophobic / omniphobic surface characteristics.

With the method as described with reference to Figures 17A to 17F, the horizontally extending membrane structure 130 and the protruding nanostructures 150 may be made from the same (first) material 114. In some examples, the first material 114 forming the membrane structure 130 and the integrally formed protruding nanostructures 150 may comprise a conducting or semiconducting characteristic. For example, the first material 114 may comprise or consist of (poly-)silicon.

In some further examples, the first material 114 forming the membrane structure 130 and the integrally formed protruding nanostructures 150 may comprise a dielectric characteristic. For example, the first material 114 may comprise or consist of silicon nitride or one or more oxides. Dielectric nanostructures 150 may be beneficial if electrical leakages shall be avoided.

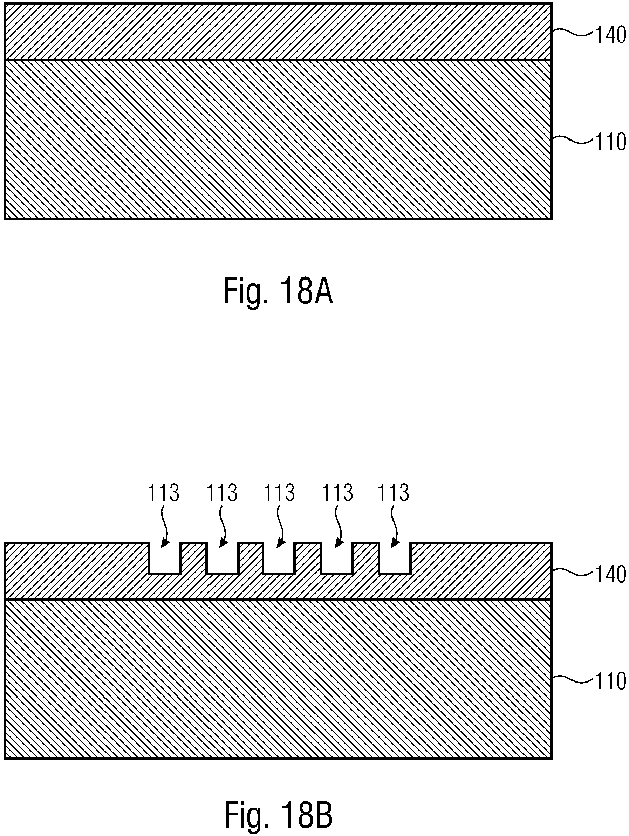

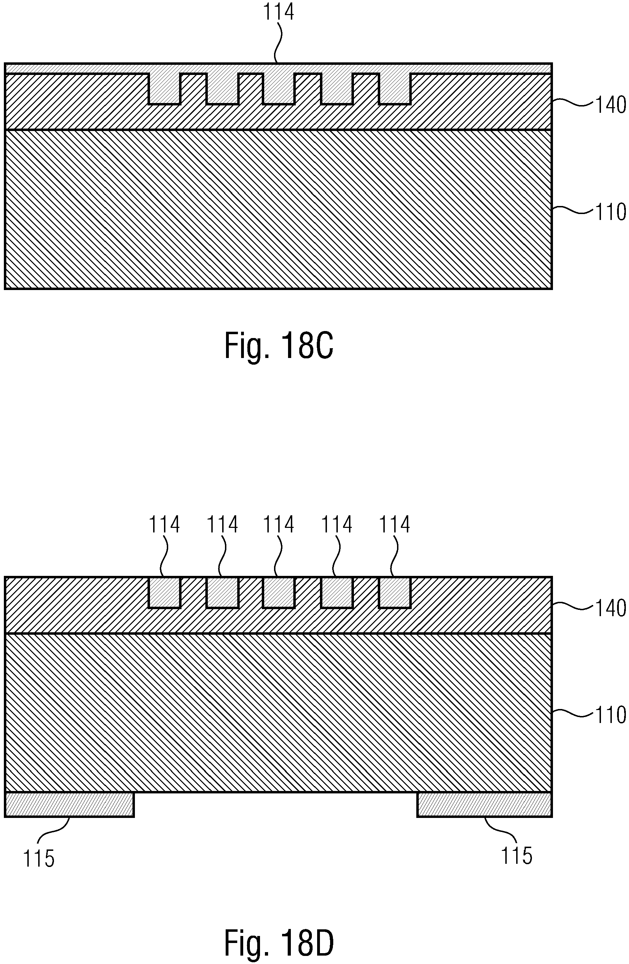

Figures 18A to 18F show an alternative method for fabricating a MEMS device 100, wherein the nanostructures 150 are also created by means of lithography. Like elements with like features, as discussed with reference to Figures 17A to 17F, are indicated with same reference numerals. Accordingly, for further details it is referred to the above discussion. A difference compared to the above discussed embodiment starts at Figure 18D. Here, the deposited first material 114 is removed from the sacrificial layer 140, while the deposited first material 114 residing inside the nanoimprints 113 is maintained. Accordingly, only the first material 114 that resides inside the nanoimprints 113 remains after this process step. In other words, the nanoimprints 113 being filled with the first material 114 remain, while the rest of the first material 114 is removed.

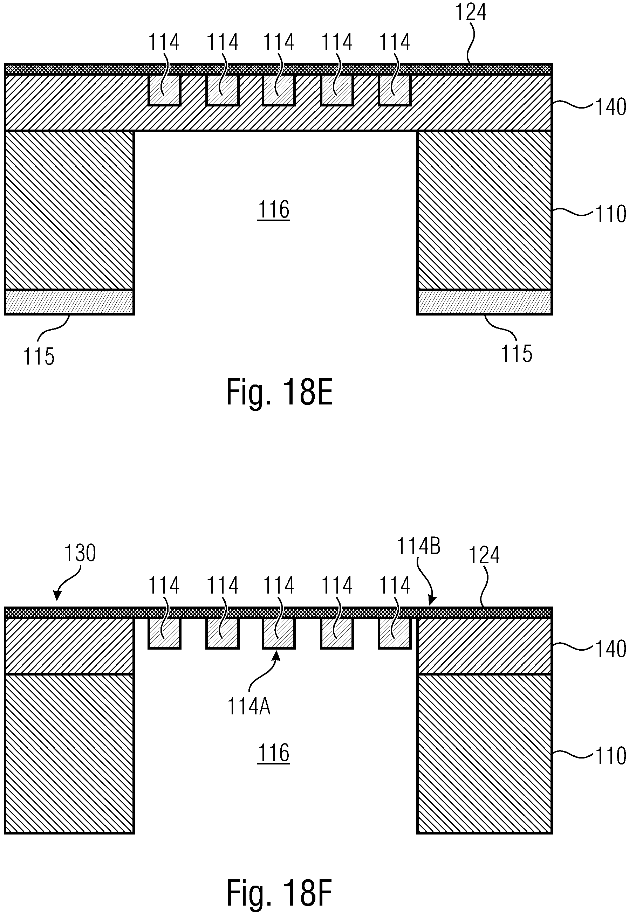

Figure 18E shows a further method step, wherein a different second material 124 is deposited onto the sacrificial layer 140 including the filled nanoimprints 113. The first material 114 residing inside the nanoimprints 113 and the deposited second material 124 may combine and/or adhere to each other. Furthermore, a cavity 116 may be structured into substrate 110, in the way as described above with reference to Figure 17E.

Figure 18F shows a further method step, in which the nanoimprints 113 being filled with the first material 114 and the deposited layer of the second material 124 are released by selectively removing the sacrificial layer 140 through the cavity 116. For example, a RIE process may be used for selectively removing portions of the sacrificial layer 140 that are located inside the cavity 116. In result, the (meanwhile released) second material 124 forms a horizontally extending membrane structure 130. Any of the first material 114 that was previously filled inside the (meanwhile released) nanoimprints 113 form upright (e.g., vertically extending) nanostructures 150 protruding from at least one of the membrane surfaces 114A, 114B of the membrane structure 130, as discussed above.

Accordingly, the horizontally extending membrane structure 130 is made from the subsequently deposited second material 124, and the protruding nanostructures 150 are made from the first material 114. The membrane structure 130 and the protruding nanostructures 150 may be firmly bonded. Furthermore, the protruding nanostructures 150 may face and extend into the cavity 116.

In some examples, the second material 124 forming the membrane structure 130 may comprise a conducting or semiconducting characteristic. For example, the second material 124 may comprise or consist of (poly-)silicon. The first material 114 forming the protruding nanostructures 150 may comprise a dielectric characteristic. For example, the first material 114 may comprise or consist of silicon nitride (Si₃N₄) or one or more oxides. Dielectric nanostructures 150 may be beneficial if electrical leakages shall be avoided.

Accordingly, with the method as described with reference to Figures 18A to 18F, the horizontally extending membrane structure 130 and the protruding upright nanostructures 150 may be made from different materials. For example, a (semi-)conducting membrane structure 130 may be provided, which comprises dielectric nanostructures 150.

The above embodiments concern methods for creating a horizontally extending membrane structure 130 with protruding upright (e.g., vertically extending) nanostructures 150, wherein said protruding nanostructures 150 faced the cavity 116. In the following, some further embodiments will be described which provide for a method for creating a horizontally extending membrane structure 130 with protruding upright (e.g., vertically extending) nanostructures 150, wherein said protruding nanostructures 150 face away from the cavity 116. It is to be noted that these embodiments may be combined with each other, e.g., for creating a first set of protruding nanostructures 150 facing the cavity 116 in combination with a second set of protruding nanostructures 150 facing away from the cavity 116.

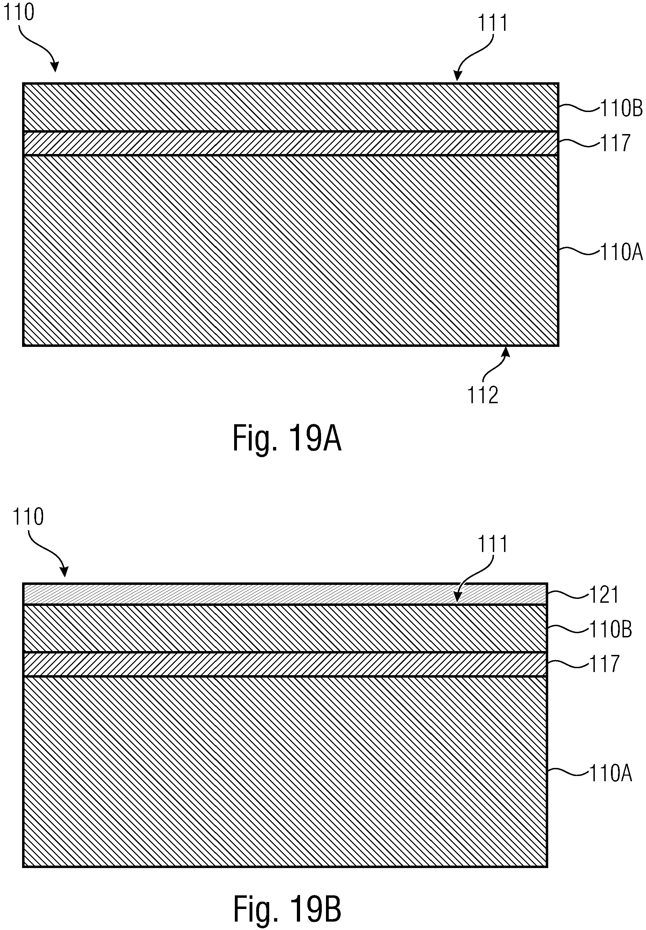

Figures 19A to 19J show an embodiment for creating protruding nanostructures 150 according to a top-down approach. Like elements with like features, as discussed with reference to the above Figures, are indicated with same reference numerals. Accordingly, for further details it is referred to the above discussion.

In Figure 19A, a substrate 110 is provided having a first substrate surface 111 and an opposite second substrate surface 112. The substrate 110 may comprise or consist of silicon. In this non-limiting example, a silicon-on-insulator (SOI) substrate is shown, which may comprise an insulating layer 117. However, the insulating layer 117 is optional. The insulating layer 117 may comprise or consist of one or more oxides, for example silicon oxide (SiO₂). The insulating layer 117 may divide the substrate 110 into a first substrate portion 110A and a second substrate portion 110B.

Figure 19B shows a further method step, wherein a material layer 121 is deposited onto the first substrate surface 111. The material layer 121 may comprise or consist of tetraethoxysilane (TEOS). Alternatively, the material layer 121 may comprise or consist of one or more oxides.

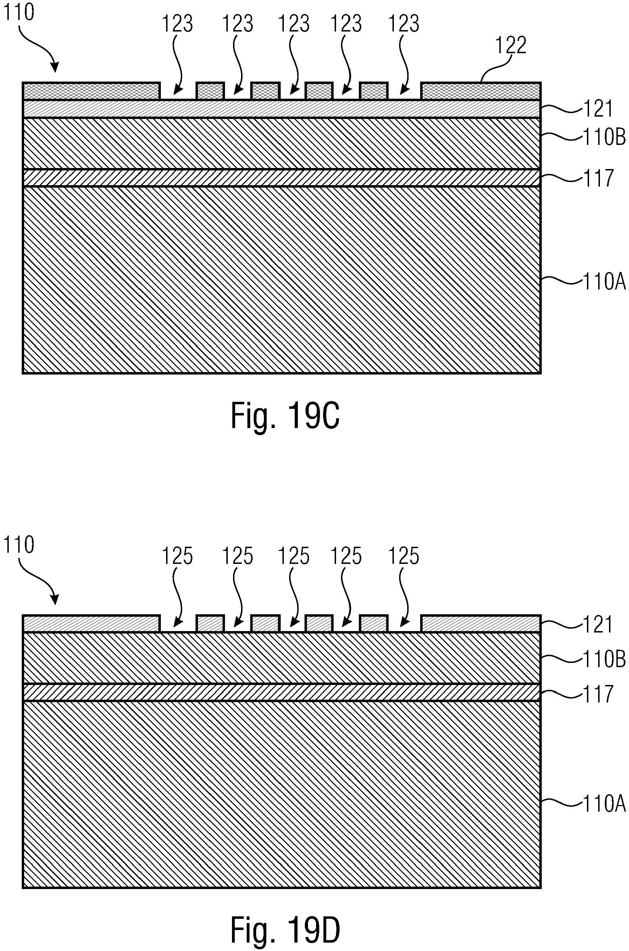

Figure 19C shows a further method step, wherein a thin photoresist 122 is applied onto the material layer 121. The photoresist 122 may be nanopatterned for creating a pattern with a plurality of openings 123 having dimensions in the range of nanometers. The nanopatterned photoresist 122 may provide a negative form for patterning the adjacent material layer 121 underneath.

Figure 19D shows a further method step, wherein the material layer 121 is patterned by means of the photoresist 122. Accordingly, the nanopattern of the photoresist 122 is transferred to the material layer 121 such that the material layer 121 comprises a pattern with a plurality of openings 125 having dimensions in the range of nanometers.

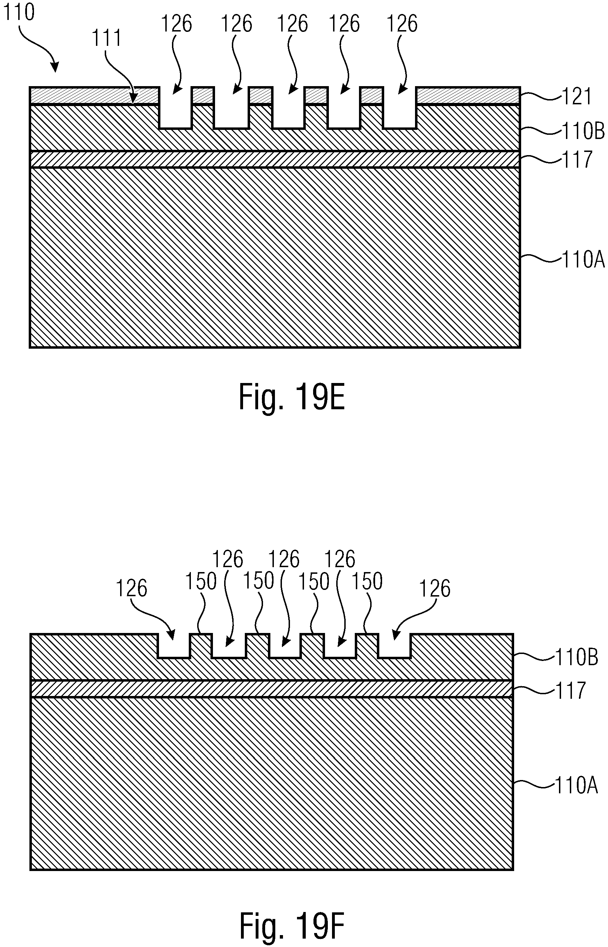

Figure 19E shows a further method step, wherein the first substrate surface 111 is structured using the nanopatterned material layer 121 as a mask. Vertical openings 126 are structured into the first substrate surface 111, e.g., by using a RIE process. The openings 126 may extend vertically into the substrate 110. The openings 126 may comprise dimensions in the range of nanometers.

Figure 19F shows a further method step, wherein the material layer 121 is removed from the substrate 110. The first substrate surface 111 is structured as described above, i.e., it comprises a pattern with a plurality of openings 126 having dimensions in the range of nanometers. Substrate material remaining laterally between adjacent openings 126 forms upright (e.g., vertically extending) nanostructures 150.

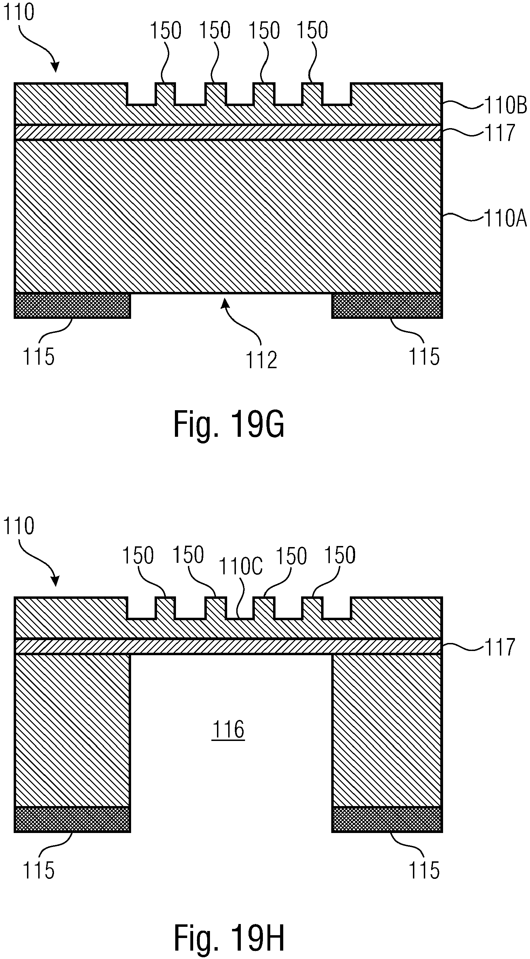

Figure 19G shows a further method step, wherein a thick negative photoresist 115 is applied to the second substrate surface 112. The photoresist 115 provides a negative form for a cavity 116 that is created in the next step, as shown in Figure 13H. A portion of the second substrate surface 112 that is located opposite to the upright nanostructures 150 remains uncovered, i.e., it is not covered with the photoresist 115.

Figure 19H shows a further method step, in which the cavity 116 is structured into substrate 110. The cavity 116 is structured into that portion of the second substrate surface 112 that is not covered with the photoresist 115. Accordingly, the cavity 116 is positioned opposite to the upright nanostructures 150.

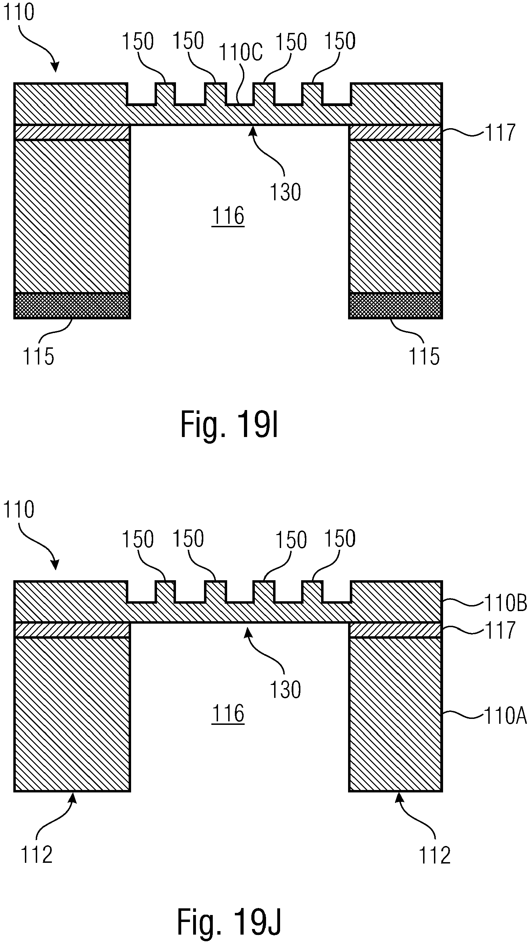

The cavity 116 is not structured through the entire substrate 110. Instead, the cavity 116 is structured such that it stops before reaching the nanostructures 150. Accordingly, a substrate portion 110C between the nanostructures 150 and the cavity 116 remains. This remaining substrate portion 110C may later form the horizontally extending membrane structure (c.f. Figure 19J) from which the nanostructures 150 protrude. The remaining substrate portion 110C may comprise a thickness of only a few nanometers (e.g., between 300 nm and 1.100 nm).

As mentioned above, the substrate 110 may comprise an optional etch stop layer 117. If the etch stop layer 117 is available, as exemplarily depicted in Figure 19H, the cavity 116 may be structured until reaching the etch stop layer 117. However, if the etch stop layer 117 is not available, the structuring process of creating the cavity 116 may be precisely controlled such that the above mentioned substrate portion 110C remains between the cavity 116 and the nanostructures 150.

Figure 19I shows a further optional method step, wherein the optional etch stop layer 117 is removed inside the cavity 116 for releasing the above discussed remaining substrate portion 110C. Thus, the remaining substrate portion 110C forms the horizontally extending membrane structure 130 from which the upright nanostructures 150 protrude. Of course, if the optional etch stop layer 117 was not present, the remaining substrate portion 110C would not have to be released but it would already form the membrane structure 130 in the previous process step (Figure 19H).

Figure 19J shows a further method step, wherein the thick negative photoresist 115 is removed from the second substrate surface 112.

As mentioned above, the substrate 110 may be divided into a first substrate portion 110A and a second substrate portion 110B. For example, at least the second substrate portion 110B may comprise or consist of a CMOS-compatible material, e.g., silicon, silicon carbide (SiC), gallium nitride (GaN), carbon, metals, polymers.

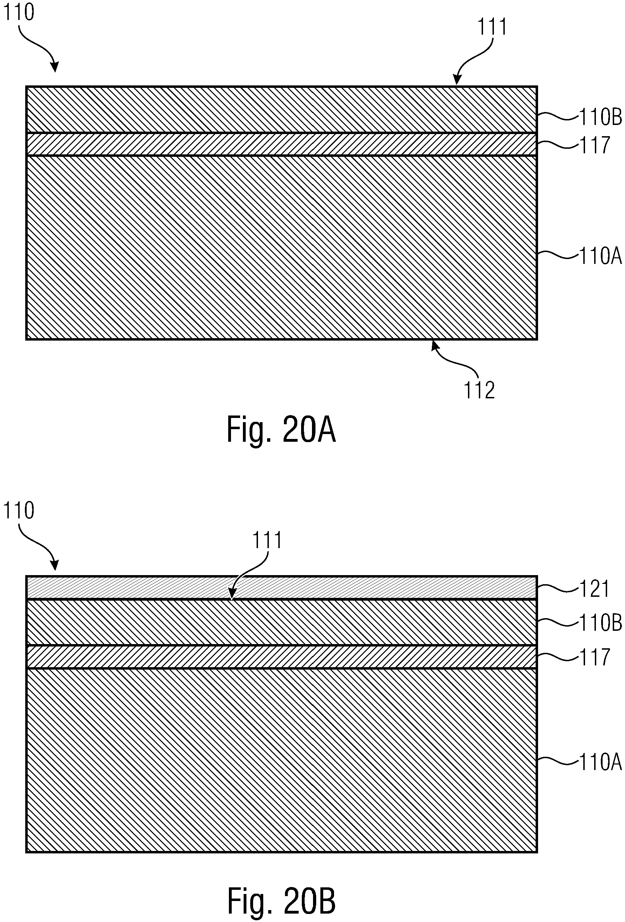

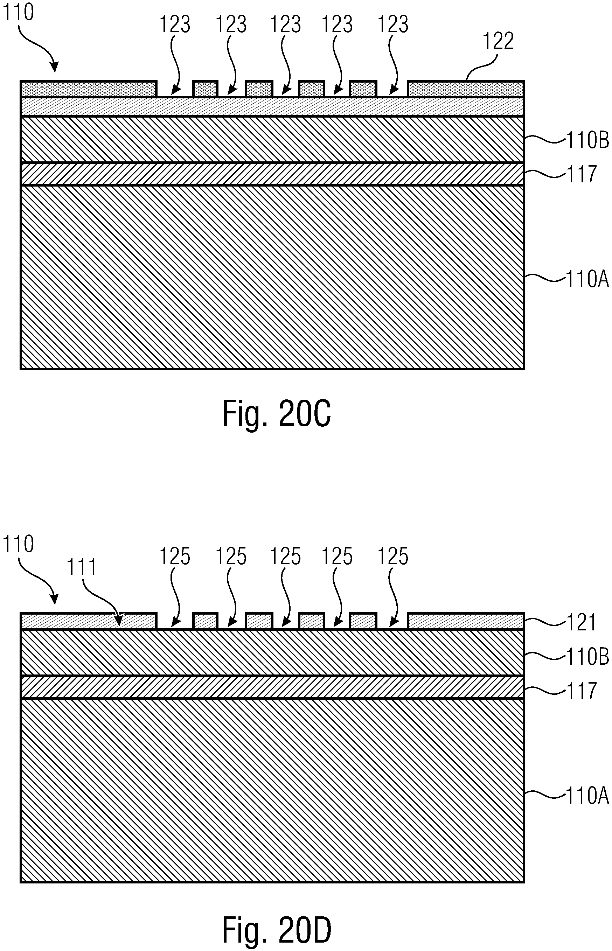

While Figures 19A to 19J showed a top-down approach. An alternative bottom-up approach for creating the protruding upright nanostructures 150 will be described in the following with reference to Figures 20A to 20H.

The method steps as shown in Figures 20A to 20D substantially correspond to the method steps as discussed above with reference to Figures 19A to 19D. Accordingly, like elements with like features, as discussed with reference to Figures 19A to 19D, are indicated with same reference numerals. Thus, for further details it is referred to the above discussion.

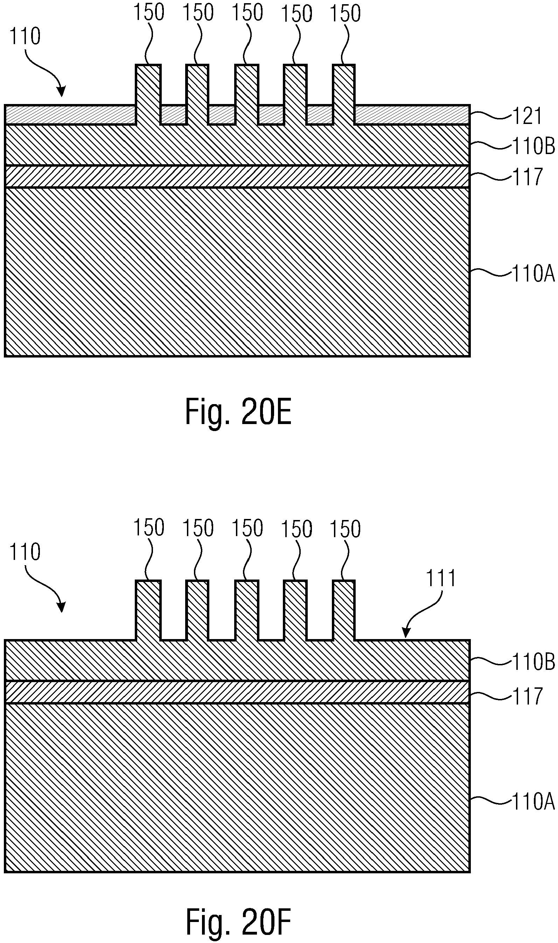

Figure 20E shows a method step, wherein upright nanostructures 150 are created at the first substrate surface 111, e.g., by growing. For example, the upright nanostructures 150 can be grown inside the openings 125 provided in the material layer 121 (c.f. Figure 20D). Alternatively, methods to bottom-up grow the silicon nanostructures 150 may include vapor-liquid-solid (VLS), solution-liquid-solid (SLS), and electrochemical methods.

Figure 20F shows a further method step, wherein the material layer 121 is removed such that only the upright nanostructures 150 may remain on the first substrate surface 111.

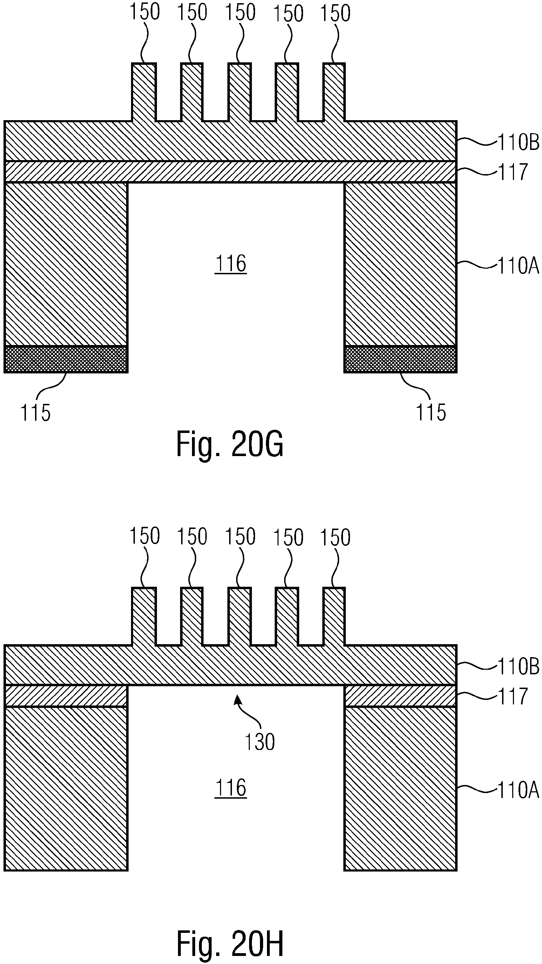

Then, the method step as shown in Figure 20G corresponds to the method step as previously discussed with reference to Figure 19H, and the method step as shown in Figure 20H corresponds to the method steps as previously discussed with reference to Figures 19I and 19J. Accordingly, like elements with like features are again indicated with same reference numerals, and for further details it is referred to the above discussion.

Summarizing, Figures 17A to 17F and Figures 18A to 18F showed method steps for creating a membrane structure 130 with protruding nanostructures 150 that faced away from the cavity 116, respectively. Figures 19A to 19J and Figures 20A to 20H showed method steps for creating a membrane structure 130 with protruding nanostructures 150 that faced the cavity 116, respectively.

Furthermore, in the method steps as shown in Figures 17A to 17F, Figures 18A to 18F and Figures 19A to 19J, the nanostructures 150 may be created in the first substrate surface 111 by structuring / patterning the substrate 110. In all of these embodiments, the substrate 110 may be structured / patterned by using photolithography or laser structuring. For example, the nanostructures 150 may be configured as so-called laser induced periodical structures (LIPSS) which may be created by femtosecond lasers. Additionally or alternatively, a direct laser interference patterning (DLIP) process may be used for creating the nanostructures 150 in the first substrate surface 111. Additionally or alternatively, a direct laser writing (DLW) process may be used for creating the nanostructures 150 in the first substrate surface 111.

In each embodiment discussed herein, the protruding upright nanostructures 150 may be configured as three-dimensional structures, as exemplarily discussed above with reference to Figures 4, 5 and 6.

Summarizing, one of the core solutions of the herein described innovative concept is the provision of a nanostructured membrane and its applications on MEMS devices 100, like MEMS microphones and environmental barriers. The integrated nanostructures 150 can result in (super)hydrophobic or omniphobic surface characteristics to repel incoming liquid droplets.

Parts of this disclosure concern design/concept and fabrication processes of upright (e.g., vertical) nanostructure arrays on membranes 130 of MEMS microphones and environmental barriers. MEMS microphones and environmental barriers with integrated upright nanostructure arrays yield (super)omniphobic membrane surfaces.

For example, a MEMS microphone with a superomniphobic nanostructure array-integrated membrane comprises a high environmental robustness. The present innovative concept allows to provide MEMS microphones with integrated nanostructures 150 either directly on the MEMS membrane 130 or on a discrete environmental barrier.

The common approach to increase the environmental robustness of MEMS microphones is by integrating external environmental barriers made of polymer having hydrophobic and oleophobic characteristics into the package. The environmental barrier covering the sound port is located either inside (directly underneath the MEMS microphone) or outside the metal package lid (embedded on the structured printed circuit board (PCB)). Moreover, only SAMs deposited on planar silicon surface might also result in hydrophobic characteristics. However, such organic materials are known to degrade within device operation time. Thus, instead of only using a chemical approach, the present concept combines physical and chemical methods into one (i.e., SAM/Si nanopillars) to reach higher environmental robustness.

The herein described innovative concept has, among others, the following advantages:
- Direct protection of the MEMS microphone chip
   ∘ Nanostructure arrays can be directly integrated into the MEMS device (e.g. underneath the bottom membrane of an SDM) and allow to directly protect it from the environment. This possibly allows to fabricate a MEMS microphone system that does not need additional environmental barrier components to achieve high water/oil-protection levels.
- Liquid repellent surface of MEMS membrane
   ∘ Compared to planar MEMS membrane, the nanostructure array-integrated MEMS membrane will provide (super)omniphobic surface that is able to repel the water/other liquids. Thus, it can also potentially provide self-cleaning feature because the approaching liquid droplets will bounce or roll off and simultaneously take the particles away from the membrane surface.
- Fabrication process of nanostructures adapted from existing technology
   ∘ Despite the required adjusted structure sizes and designs, currently existing technology can be used as a basis for the process development. Thus, the realization and optimization of the proposed upright nanostructures will not start from 'zero'. However, in terms of producing very small nanostructures (smaller than current MEMS bumps) and large-scale production (productive fabrication in front line), adaptations of lithography tools may be necessary.
- Flexible design related to combination with other organic or inorganic materials
   ∘ Silicon nanopillars can also be combined with either organic SAMs or other inorganic 1D nanostructures (e.g., ZnO nanowires) to increase the hydrophobicity/omniphobicity level of the membrane surfaces.

The following non limiting examples form part of the present disclosure:
According to a first example, a MEMS - microelectromechanical system - device (100) may be provided, the MEMS device (100) comprising a substrate (110) comprising a vertically extending through hole (120) (wherein the vertically extending through hole corresponds to the above discussed cavity 116) and a horizontally extending membrane structure (130) covering the through hole (120), wherein the membrane structure (130) may comprise a plurality of protruding and/or upright nanostructures (150) for providing a liquid repellent membrane surface.

According to a second example that can be combined with the first example, the upright / protruding nanostructures (150) may be configured as three-dimensional geometric structures extending from the membrane structure (130), and extending into a direction away from the membrane structure (130).

According to a third example that can be combined with one of the first and second examples, the upright / protruding nanostructures (150) may comprise at least one of:
- a diameter of ≤ 1 µm;
- a pitch, i.e., a distance between the centers of two adjacent nanostructures (150), said pitch comprising a ratio of at least pitch : diameter = 2:1;
- a width-to-height aspect ratio between 1:3 and 1:40.

According to a fourth example that can be combined with one of the preceding examples, the plurality of upright / protruding nanostructures (150) provided on the membrane structure (130) may provide a membrane surface comprising at least one of a hydrophobic and an oleophobic surface characteristic.

According to a fifth example that can be combined with one of the preceding examples, the upright / protruding nanostructures (150) may comprise at least one of the following geometrical shapes:
- a cylinder shape,
- a frustum cone shape,
- an inverted frustum cone shape,
- a T-shape, or
- a multifaceted T-shape.

According to a sixth example that can be combined with one of the preceding examples, the upright / protruding nanostructures (150) may be coated with an organic Self Assembled Monolayer - SAM -.

According to a seventh example that can be combined with one of the preceding examples, the upright / protruding nanostructures (150) may comprise inorganic nanodots (190) or nanowires (190) extending from an outer surface of the upright / protruding nanostructures (150).

According to an eighth example that can be combined with one of the preceding examples, the horizontally extending membrane structure (130) may comprise a first membrane surface (130A) facing the through hole (120) and an opposite second membrane surface (130B) facing away from the through hole (120), and the upright / protruding nanostructures (150) may be arranged on at least one of the first and second membrane surfaces (130A, 130B).

According to a ninth example that can be combined with one of the preceding examples, the MEMS device (100) may be configured as a MEMS microphone, in which the horizontally extending membrane structure (130) may be configured as a microphone sound transducer membrane, wherein the upright / protruding nanostructures (150) may be arranged at the microphone sound transducer membrane.

According to a tenth example that can be combined with one of the first to eighth examples, the MEMS device (100) may further comprise a MEMS microphone (300) comprising a microphone sound transducer membrane (310), wherein the MEMS device (100) may be configured as an environmental barrier structure comprising an environmental barrier membrane or mesh structure for protecting the microphone sound transducer membrane (310) from moisture and/or environmental particles, and wherein the horizontally extending membrane structure (130), at which the upright / protruding nanostructures (150) are arranged, may be configured as the environmental barrier membrane or mesh structure.

According to an eleventh example that can be combined with one of the ninth or tenth examples, the MEMS microphone may comprise a sound port (211) through which acoustic waves reach the membrane structure (130), wherein the membrane structure (130) may be positioned such that the upright / protruding nanostructures (150) face the sound port (211).

According to a twelfth example that can be combined with one of the preceding examples, the plurality of upright / protruding nanostructures (150) may comprise an area density of 10⁶ - 10¹⁰ nanostructures per cm².

According to a thirteenth example, a method for fabricating a MEMS device (100) is provided, the method comprising a step of providing a substrate (110) comprising a first substrate surface (111) and an opposite second substrate surface (112), wherein the substrate (110) comprises a sacrificial layer (140) arranged at the first substrate surface (111), and a step of structuring nanoimprints (113) into the sacrificial layer (140), and a step of filling the nanoimprints (113) by depositing a first material (114) onto the structured sacrificial layer (140), and a step of structuring a cavity (116) into the substrate (110), the cavity (116) being positioned opposite to the filled nanoimprints (113) and extending between the second substrate surface (112) and the sacrificial layer (140), and a step of releasing the filled nanoimprints (113) by removing the sacrificial layer (140) through the cavity (116), thereby creating a horizontally extending membrane structure (130) comprising upright / protruding nanostructures (150) that extend into the cavity (116).

According to a fourteenth example that can be combined with the thirteenth example, the horizontally extending membrane (130) and the upright / protruding nanostructures (150) may be made from the deposited first material (114).

According to a fifteenth example that can be combined with the thirteenth example, after the step of depositing the first material (114) onto the structured sacrificial layer (140), the method may further comprise steps of removing the deposited first material (114) from the sacrificial layer (140) while maintaining the deposited first material (114) inside the filled nanoimprints (113), and depositing a different second material (124) onto the sacrificial layer (140) and the filled nanoimprints (113), such that the horizontally extending membrane (130) is made from the deposited second material (124) while the upright / protruding nanostructures (150) are made from the first material (114).

According to a sixteenth example, a method for fabricating a MEMS device (100) is provided, the method comprising a step of providing a substrate (110) having a first substrate surface (111) and an opposite second substrate surface (112), and a step of creating upright / protruding nanostructures (150) in the first substrate surface (111), and a step of structuring a cavity (116) into the substrate (110), the cavity (116) being positioned opposite to the upright / protruding nanostructures (150), and the cavity (116) extending from the second substrate surface (112) up to a remaining substrate portion (110C) between the cavity (116) and the upright / protruding nanostructures (150), thereby creating a membrane structure (130) horizontally extending over the cavity (116) and having the upright / protruding nanostructures (150) integrated therein, wherein the upright / protruding nanostructures (150) face away from the cavity (116).

According to a seventeenth example that can be combined with the sixteenth example, the step of creating the upright / protruding nanostructures (150) in the first substrate surface (111) may comprises at least one of the following steps:
- structuring upright / protruding three-dimensional structures (150) into the first substrate surface using lithography, or
- growing upright / protruding three-dimensional structures (150) on top of the first substrate surface, or
- structuring upright / protruding three-dimensional structures (150) into the first substrate surface using laser structuring.

According to an eighteenth example that can be combined with one of the thirteenth to seventeenth examples, the method may further comprise a step of applying a coating onto the upright / protruding nanostructures (150), the coating comprising an organic self-assembled monolayer.

According to an nineteenth example that can be combined with one of the thirteenth to eighteenth examples, the method may further comprise a step of depositing a film of inorganic material onto the upright / protruding nanostructures (150) for forming inorganic nanoseeds, and a step of growing nanowires (190) from the deposited nanoseeds, such that the grown nanowires (190) extend from an outer surface of the upright / protruding nanostructures (150).

Although some aspects have been described in the context of an apparatus, it is clear that these aspects also represent a description of the corresponding method, where a block or device corresponds to a method step or a feature of a method step. Analogously, aspects described in the context of a method step also represent a description of a corresponding block or item or feature of a corresponding apparatus.

While this disclosure has been described with reference to illustrative embodiments, this description is not intended to be construed in a limiting sense. Various modifications and combinations of the illustrative embodiments, as well as other embodiments of this disclosure, will be apparent to persons skilled in the art upon reference to the description. It is therefore intended that the appended claims encompass any such modifications or embodiments.

## Claims

1. A method for producing a MEMS device (100), the method comprising:
providing a substrate (110) comprising a first substrate surface (111) and an opposite second substrate surface (112), wherein the substrate (110) comprises a sacrificial layer (140) arranged at the first substrate surface (111),
depositing a membrane material layer (114) onto the sacrificial layer (140),
structuring a cavity (116) into the substrate (110), the cavity (116) extending between the second substrate surface (112) and the sacrificial layer (140),
releasing the membrane material layer (114) by removing the sacrificial layer (140) from the cavity (116) such that the cavity (116) is adjacent to the membrane material layer (114), wherein the released membrane material layer (114) forms a free-standing membrane structure (130) covering the cavity (116), and
creating nanostructures (150) in at least one of the first and second membrane surfaces (114A, 114B) of the membrane material layer (114), wherein the nanostructures (150) protrude from the respective membrane surface (114A, 114B) of the membrane material layer (114),
wherein the nanostructures (150) are created by applying a laser structuring process.

2. The method according to claim 1,
wherein the step of creating the nanostructures (150) comprises a step of removing portions (118) of the membrane material layer (114) by means of one or more laser beams (180) being used in the applied laser structuring process,
wherein the nanostructures (150) remain between the removed portions (118) of the membrane material layer (114), such that the nanostructures (150) are monolithically integrated in the membrane material layer (114).

3. The method according to claim 1 or 2,
wherein the applied laser structuring process uses a femto second laser or a pico second laser.

4. The method according to claim 1 or 2,
wherein the applied laser structuring process comprises Direct Laser Interference Patterning (DLIP).

5. The method according to any one of the preceding claims,
wherein the step of creating the nanostructures (150) comprises distributing the nanostructures (150) in a random or periodic pattern along the respective membrane surface (114A, 114B) of the membrane material layer (114).

6. The method according to any one of the preceding claims,
wherein the nanostructures (150) are created in a first membrane surface (114A) of the membrane material layer (114), said first membrane surface (114A) facing the cavity (116), such that the nanostructures (150) also face the cavity (116), and
wherein the one or more laser beams (180) being used in the applied laser structuring process is/are guided through the cavity (116) so as to reach the first membrane surface (114A) of the membrane material layer (114).

7. The method according to any one of the preceding claims,
wherein the nanostructures (150) are created in a second membrane surface (114B) of the membrane material layer (114), said second membrane surface (114B) facing away from the cavity (116), such that the nanostructures (150) also face away from the cavity (116).

8. The method according to any one of the preceding claims,
wherein the one or more laser beams (180) being used in the applied laser structuring process is/are guided over the second substrate surface (112) located outside the cavity (116), such that additional nanostructures (151) are created in said second substrate surface (112).

9. The method according to any one of the preceding claims,
wherein the one or more laser beams (180) being used in the applied laser structuring process is/are guided over one or more inner substrate portions (110A) residing inside the cavity (116), such that additional nanostructures (152) are created in said one or more inner substrate portions (110A).

10. The method according to any one of the preceding claims,
wherein prior to the step of creating the nanostructures (150) by applying the laser structuring process, the method comprises steps of
creating nanopillars (155) in at least one of the first and second membrane surfaces (114A, 114B) of the membrane material layer (114) by applying a lithography and etching process, wherein said nanopillars (155) protrude from the respective membrane surface (114A, 114B) of the membrane material layer (114), and
creating the nanostructures (150) in said nanopillars (155) by applying the laser structuring process, wherein the nanostructures (150) are created in a top surface (156) of the nanopillars (155), said top surface (156) facing away from the membrane material layer (114).

11. The method according to claim 10,
wherein the nanopillars (155) comprise a diameter that is at least ten times larger than a diameter of the nanostructures (150).

12. The method according to claim 10 or 11,
wherein the step of creating the nanostructures (150) by applying the laser structuring process comprises a step of creating the nanostructures (150) in a recess (157) between two adjacent nanopillars (155).

13. The method according to any one of the preceding claims,
further comprising a step of coating the nanostructures (150) with an organic Self Assembled Monolayer - SAM - (180).

14. The method according to one of the preceding claims,
further comprising a step of growing inorganic nanodots (190) or nanowires (190) on an outer surface of the nanostructures (150), said inorganic nanodots (190) or nanowires (190) vertically extending away from said outer surface of the nanostructures (150).

15. A MEMS - microelectromechanical system - device (100) comprising:
a substrate (110) comprising a cavity (116) extending vertically through the substrate (110) and a membrane material layer (114) being attached to the substrate (110), said membrane material layer (114) forming a horizontally extending free-standing membrane structure (130) covering the cavity (116),
wherein the membrane material layer (114) comprises a plurality of nanostructures (150) for providing a liquid repellent membrane surface, wherein the nanostructures (150) protrude from at least one of two opposing membrane surfaces (114A, 114B) of the membrane material layer (114), and
wherein the nanostructures (150) are created by a laser structuring process such that they are monolithically integrated in the membrane material layer (114).

16. The MEMS device (100) according to claim 15,
wherein the nanostructures (150) comprise a non-flat top section.

17. The MEMS device (100) according to claim 15 or 16,
wherein the plurality of nanostructures (150) provided on the membrane material layer (114) create a rough nanostructured membrane surface (114A, 114B) having at least one of a hydrophobic and an oleophobic surface characteristic.

18. The MEMS device (100) according to claim 17,
wherein the rough nanostructured membrane surface (114A, 114B) comprises a contact angle of at least 120°, or a contact angle of at least 150°.

19. The MEMS device (100) according to any one of claims 15 to 18,
wherein the MEMS device (100) is arranged inside a MEMS pressure transducer package (200) comprising a fluid entry port (211) through which environmental fluid can enter the package (200), and
wherein the membrane material layer (114) of the MEMS device (100) is positioned such that the nanostructures (150) face the fluid entry port (211).
